# EUROPEAN PATENT APPLICATION

(11) **EP 4 567 867 A1**
(43) Date of publication of application: **11.06.2025**
(21) Application number: 24218385.3
(22) Date of filing: 28.11.2024
(51) Int. Cl.: H01L 21/48

(54) **SUBSTRATE FOR ELECTRICAL SUBSTRATE FOR ELECTRICAL CONNECTION BETWEEN ELECTRONIC COMPONENTS AND ELECTRONIC DEVICE**

(30) Priority: 30.11.2023 KR 20230170852
(62) Divisional of application: 24216097.6
(71) Applicant: UNIST (Ulsan National Institute of Science and Technology), Ulsan, Seoul 44919 (KR)
(72) Inventor: KWON, Jimin, 44919 Ulsan (KR); JUNG, Haksoon, Ulsan (KR)
(74) Representative: Dantz, Jan Henning

(57) **Abstract**

A semiconductor packaging module comprises a single first semiconductor chip, and a substrate including a first surface facing a lower surface of the first semiconductor chip, a second surface facing the first surface, and at least one first interconnect structure inside between the first surface and the second surface, wherein the at least one first interconnect structure comprises a first portion exposed through the first surface, a second portion exposed through the second surface, and a line connecting between the first portion and the second portion, wherein the first portion is electrically connected to the first semiconductor chip, and the second portion is electrically connectable to another electronic component, and wherein the line is transverse to the body of the single layer structure, and is formed with a specific slope in at least some sections.

## Description

### BACKGROUND

### 1. Field

Various embodiments of the present invention relate to apparatus, server, system, and method of operating the same for customized semiconductor packaging based on 3D printing.

### 2. Description of Related Art

The semiconductor industry has become more lightweight, miniaturized, multifunctional, and high performance at low prices.

The semiconductor process includes wafer manufacturing, a preprocess for generating chips, and a postprocess for packaging chips, and braking the system speed of improvement through semiconductor miniaturization technology based on Moore's law, and the postprocess, semiconductor packaging, is attracting attention as a key technology for making new added values.

Semiconductor packaging is a technology for electrical connection and protection between semiconductor parts, and chip performance can be greatly improved by increasing the electrical connection distance and number between semiconductor parts.

Recently, as various types of application products are developed, the need for development of packaging technology to provide customized packaging structures for demands of semiconductor customers that are diversified is increased.

### SUMMARY

Semiconductor packaging is a technology for electrical connection and protection between semiconductor parts, and is a technology that can significantly improve chip performance by increasing the electrical connection distance and number between semiconductor parts. However, in the related art, costs of interconnection processes occupy most of the costs of semiconductor packaging, costs of interconnection structures of various patterns are increased, and as the structure becomes complicated, the costs are increased sharply. In addition, because semiconductor is used not only in the IT product but also in the AI, vehicle, and smart factory, various kinds of customer-customized semiconductor chips are needed, but it is difficult to solve this with the related art constructed semiconductor production facilities.

According to various embodiments, the apparatus, server, system, and methods for 3D printing-based customer-customized semiconductor packaging can simplify interconnection processes and reduce the costs of interconnection processes through the formation of interconnection structures using 3D printing. In addition, the apparatus, server, system, and methods for 3D printing-based customer-customized semiconductor packaging can create a substrate having a shape (e.g., suitable for the shape of the empty space in the product) suitable for the purpose and form interconnection structures of various patterns, and thus can optimize process cost items by excluding a separate interconnection process from the semiconductor package process.

In addition, in the case of a semiconductor substrate, it is also necessary to improve a material so as to lower the dielectric constant and CTE according to the use of a semiconductor, and to solve this problem, a polymer and an oligomer in combination with a specific monomer may be used to improve the above-described problem.

According to various embodiments, there may be provided a substrate for electrical connection between electronic components, the substrate including: a body having a single layer structure; and at least one interconnect having conductivity formed inside the body, wherein the at least one interconnect includes one side and the other side exposed to the outside of the body, and a line connecting the one side and the other side, and wherein the line intersects in a transverse direction or a longitudinal direction through the inside of the body of the single layer structure and is implemented to have a specific curvature in some sections.

According to an embodiments a substrate for electrical connection between electronic components is provided, the substrate comprising a body having a single layer structure, and at least one interconnect structure having conductivity formed inside the body, wherein the at least one interconnect structure comprises a first end portion exposed through a first surface of the substrate, a second end portion exposed through a second surface of the substrate, and a line connecting the first end portion and the second end portion, and wherein the line is crossed in a transverse direction and/or a longitudinal direction through the inside of the body of the single layer structure, and is formed at a specific curvature in some sections.

According to various embodiments, there may be provided an electronic apparatus including: a plurality of electronic components; and a substrate including a body having a single layer structure, and at least one interconnect having conductivity formed inside the body, wherein the at least one interconnect includes one side and the other side exposed to the outside of the body, and a line connecting the one side and the other side, and wherein the line intersects in a transverse direction or a longitudinal direction through the inside of the body of the single layer structure and is implemented to have a specific curvature in some sections, and wherein a first electronic component and a second electronic component among the plurality of electronic components are electrically connected by the at least one interconnect.

According to various embodiments, the apparatus, server, system, and methods for 3D printing-based consumer-customized semiconductor packaging, can simplify the interconnection process and reduce the cost of the interconnection process by forming an interconnection structure using 3D printing.

According to various embodiments, the apparatus, server, system, and methods for 3D printing-based consumer-customized semiconductor packaging, create a shape suitable for purpose (e.g., suitable for the shape of an empty space inside the product) and form an interconnection structure of various patterns, thereby excluding a conventional separate interconnection process from the semiconductor package process and optimizing the process cost item.

In particular, according to various embodiments, the oligomer including the monomer represented by Chemical Formula 1 has a structure that is mostly comprised of a polyimide component known to have a low dielectric constant and a low CTE, and thus may have a desired dielectric constant value and a CTE value, and has a structure having a very large number of (meth)acrylate functional groups per unit volume, and when the (meth)acrylate functional groups are sensitive to light, the oligomer is interconnected to form a very dense polymer network, and since the structural structure has a low CTE value due to a lower expansion rate due to heat.

In addition, the oligomer including the monomer represented by Chemical Formula 1 has a structure having a very large number of methacrylate functional groups per unit volume, and thus has a very low free volume that is not sensitive to light, and thus achieves a very high resolution (10 µm or less) required in semiconductor packaging.

According to various embodiments, the technical solutions are not limited to the above-described solutions, and the solutions that are not mentioned may be clearly understood by those skilled in the art from the specification and the accompanying drawings.

### BRIEF DESCRIPTION OF THE DRAWINGS

FIG. 1 is a diagram illustrating an example of a component of a customized printing system according to various embodiments.
FIG. 2 is a diagram for describing an example of an application product of a structure produced by a customized printing system according to various embodiments.
FIG. 3 is a diagram for describing an example of a configuration of a server and a user device according to various embodiments.
FIG. 4 is a diagram for describing an example of a design program according to various embodiments.
FIG. 5 is a diagram for describing an example of a conversion program according to various embodiments.
FIG. 6 is a diagram for describing an example of a configuration of a package device according to various embodiments.
FIG. 7 is a diagram for describing an example of an implementation of a packaging device according to various embodiments.
FIG. 8 is a flowchart illustrating an example of a process according to various embodiments.
FIG. 9 is a diagram for describing an example of a substrate formation process, a metallization process, a bump formation process, and a bonding process according to various embodiments.
FIG. 10A is a flowchart illustrating an example of a formation process of a 3DP-based substrate according to various embodiments.
FIG. 10B is a diagram for describing an example of a material of a substrate including Chemical Formula 1 according to various embodiments.
FIG. 10C is a diagram for describing an example of a material of a substrate including Chemical Formula 2 according to various embodiments.
FIG. 11A is a flowchart illustrating an example of a formation process of a 3DP-based substrate according to various embodiments.
FIG. 11B is a diagram for describing an example of a process of forming an external structure of a substrate according to various embodiments.
FIG. 11C is a diagram for describing an example of a process of forming an external structure of a substrate according to various embodiments.
FIG. 12 is a flowchart illustrating an example of an operation for generating a substrate based on a drawing file received from user devices according to various embodiments.
FIG. 13 is a diagram for describing an example of an operation of generating different substrates according to a drawing file received from user devices according to various embodiments.
FIG. 14 is a flowchart illustrating an example of an operation of correcting a size of a substrate with at least a part of a 3DP-based substrate formation operation according to various embodiments.
FIG. 15 is a diagram for describing an example of an operation of correcting a size according to various embodiments.
FIG. 16 is a diagram for describing examples of an operation of correcting a size of a server according to various embodiments.
FIG. 17 is a flowchart illustrating an example of a metallization process according to various embodiments.
FIG. 18 is a diagram for describing an example of a metallization device for a metallization process according to various embodiments.
FIG. 19 is a diagram for describing an example of an operation of removing internal defects formed in a through structure of a substrate during a metallization process according to various embodiments.
FIG. 20 is a diagram for describing an example of a packaging structure and an application product according to various embodiments.
FIG. 21 is a diagram for describing an example of a first type of a packaging structure according to various embodiments.
FIG. 22 is an exploded perspective view of an example of a first type packaging structure according to various embodiments.
FIG. 23 is a diagram for describing various examples of a first type packaging structure according to various embodiments.
FIG. 24 is a diagram for describing various examples of a second type packaging structure according to various embodiments.
FIG. 25 is a diagram for describing an example of a packaging structure used in an application product according to various embodiments.
FIG. 26 is a diagram for describing an example of a first type packaging structure used in a chip package according to various embodiments.
FIG. 27 is a diagram for describing an example of a second type packaging structure according to various embodiments.
FIG. 28 is a diagram for describing an example of a packaging structure used in an antenna in package according to various embodiments.
FIG. 29 is a diagram for describing an example of a packaging structure used in an antenna in package according to various embodiments.

### DETAILED DESCRIPTION

The electronic device according to various embodiments disclosed in the present disclosure may be various types of devices. The electronic device may include, for example, a portable communication device (e.g., a smartphone), a computer device, a portable multimedia device, a portable medical device, a camera, a wearable device, or a home appliance. The electronic device according to the embodiment of the present disclosure is not limited to the above-described devices.

It should be understood that various embodiments of the present disclosure and the terms used in the same are not intended to limit the technical features described in the present disclosure to particular embodiments, but to include various changes, equivalents, or alternatives to the corresponding embodiment. With regard to the description of the drawings, similar reference numerals may be used for similar or related components. The singular form of a noun corresponding to an item may include one or more of the items unless the relevant context clearly indicates otherwise. In the present document, each of the phrases such as "a or b," "at least one of a and b," "at least one of a or b," "a, b, or c," "at least one of a, b, and c," and "at least one of a, b, or c" may include any one of the items listed together in the corresponding phrase among the phrase, or any combination thereof. The terms "first," "second," or "first" may be used to simply distinguish the corresponding component from other corresponding components, and the corresponding components are not limited in other aspects (e.g., importance or order). When a (e.g., first) component is referred to as "coupled" or "connected" with or without the term "functionally" or "communicatively" in another (e.g., second) component, it means that the component may be connected to the other component directly (e.g., wiredly), wirelessly, or through a third component.

The term "module" used in various embodiments of the present disclosure may include a unit implemented in hardware, software, or firmware, and may be used interchangeably with terms such as logic, logic block, component, or circuit. The module may be an integrated component or a minimum unit of the component or a part thereof that performs one or more functions. For example, according to an embodiment, the module may be implemented in the form of an application-specific integrated circuit (ASIC).

Various embodiments of the present disclosure may be implemented as software (e.g., a program) including one or more instructions stored in a storage medium (e.g., internal memory) or external memory that can be read by a machine (e.g., an electronic device). For example, a processor (e.g., processor) of a machine (e.g., an electronic device) may invoke at least one instruction from the storage medium and execute it. This enables the machine to perform at least one function in accordance with the at least one invoked instruction. The one or more instructions may include code generated by a compiler or code executable by an interpreter. The machine-readable storage medium may be provided in the form of non-transitory storage medium. Here, "non-transitory" is a device in which a storage medium is tangible and does not include a signal (e.g., electromagnetic wave), and this term does not distinguish between a case where data is semi-permanently stored in a storage medium and a case where data is temporarily stored.

According to an embodiment, a method according to various embodiments disclosed in this document may be included and provided in a computer program product. The computer program product may be traded between a seller and a buyer as a product. The computer program product may be distributed in the form of a storage medium (e.g., compact disc read only memory (CD-ROM)) readable by a device, or may be distributed (e.g., downloaded or uploaded) online through an application store (e.g., Play StoreTM), or directly between two user devices (e.g., smart phones). In the case of online distribution, at least a part of the computer program product may be temporarily stored or generated in a storage medium readable by a device such as a server of a manufacturer, a server of an application store, or a memory of a relay server.

According to various embodiments, each component (e.g., module or program) of the above-described components may include a single entity or a plurality of entities, and some of the plurality of entities may be separated from other components. According to various embodiments, one or more components or operations among the above-described corresponding components may be omitted, or one or more other components or operations may be added. Alternatively or additionally, a plurality of components (e.g., modules or programs) may be integrated into one component. In this case, the integrated component may perform one or more functions of each component of the plurality of components in the same or similar manner as that performed by the corresponding component among the plurality of components before the integration. According to various embodiments, operations performed by a module, a program, or another component may be sequentially, parallelly, repeatedly, or heuristically, one or more of the operations may be executed in a different order, omitted, or one or more other operations may be added.

According to various embodiments, a substrate for electrical connection between electronic components may include a body having a single layer structure; and at least one interconnect having conductivity formed inside the body, wherein the at least one interconnect includes one side and the other side exposed to the outside of the body and a line connecting the one side and the other side, and wherein the line is implemented to have a specific curvature in some sections through the inside of the body in the single layer structure.

According to various embodiments, the at least one interconnect may include a first interconnect and a second interconnect, wherein the specific slope of the first interconnect is a first slope, and the specific slope of the second interconnect is a second slope different from the first slope.

According to various embodiments, the body may be implemented to correspond to the shape of an empty space inside an electronic product in which the substrate is placed on the basis on the 3D printing process.

According to various embodiments, the one side of the at least one interconnect is connected to a first electronic component of the electronic device, and the other side is connected to a second electronic component of the electronic device.

According to various embodiments, the at least one interconnect may include a plurality of conductive members, and the first density of the plurality of conductive members in a first region adjacent to the first electronic component of the substrate may be implemented to be different from the second density of the plurality of conductive members in a second region adjacent to the second electronic component of the substrate.

According to various embodiments, the body may be provided with a substrate implemented to include at least one structure and/or at least one member in a portion other than the portion in which the at least one interconnect is disposed.

According to various embodiments, the at least one structure may include an empty space structure for emitting heat generated from the substrate.

According to various embodiments, the substrate may be connected to an additional structure including at least one interconnect.

According to various embodiments, the density of the at least one interconnect of the substrate may be implemented to be lower than the density of the other at least one interconnect of the additional structure.

According to various embodiments, the substrate and the additional substrate may be connected to each other in a way that the substrate and the additional substrate are bonded to each other, or a substrate may be provided in a way that the substrate and the additional substrate are laminated on the substrate.

According to various embodiments, an electronic device may include: a plurality of electronic components; and a substrate including a body having a single-layer structure, and at least one interconnect having a conductivity formed inside the body, wherein the at least one interconnect includes one side and the other side exposed to the outside of the body, and a line connecting the one side and the other side, wherein the line intersects the inside of the body of the single-layer structure in a transverse direction or a longitudinal direction, and has a specific curvature in some sections, and wherein a first electronic component and a second electronic component among the plurality of electronic components are electrically connected by the at least one interconnect.

According to various embodiments, as a material for a substrate, at least one monomer that can be cured by a 3D printing process may be provided, wherein the at least one monomer has a resolution of um by the 3D printing process.

According to various embodiments, there is provided a material for a substrate for electrical connection between electronic components including a first composition including an oligomer including a monomer represented by the following Chemical Formula 1;
a compound including at least two acrylate functional groups; and a photoinitiator as a material for a substrate, or a cured product thereof. In Chemical Formula 1,
R1 to R4 are the same as or different from each other, and are each independently a substituted or unsubstituted C1 to C40 alkyl group,
Ar1 and Ar2 are the same as or different from each other, and are each independently a (meth)acrylate functional group-containing substituent, and n1 is an integer of 1 or more and 50 or less.

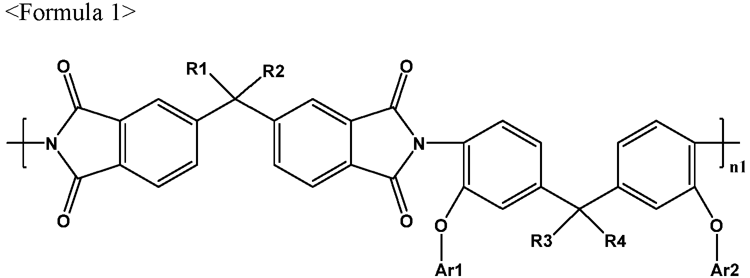

According to various embodiments, the at least one monomer may be provided with a material for a substrate, which may be implemented with a surface roughness of 0.5 um or less when cured.

According to various embodiments, a material for a substrate for electrical connection between electronic components is provided in which a weight ratio of an oligomer including a monomer represented by Chemical Formula 1 to a compound including at least two acrylate functional groups is 40:30 to 75:10.

According to various embodiments, a material for a substrate for electrical connection between electronic components is provided, further comprising a second composition comprising an oligomer comprising a monomer represented by the following Chemical Formula 2; a compound comprising at least two acrylate functional groups; and a photoinitiator; or a cured product thereof.

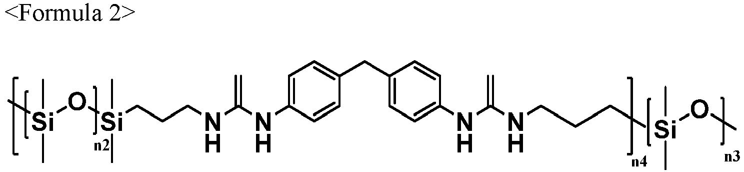

In Chemical Formula 2, n2 and n3 are an integer of 30 to 60, and n4 is an integer of 3 to 100.

According to various embodiments, a process method may be provided, and the process method may comprise: generating a substrate including at least one penetration structure based on 3D printing; hydrophilizing an inner surface of the at least one penetration structure; providing a fluid metal to the inner surface of the hydrophilized at least one penetration structure; and forming a metal inside the at least one penetration structure based on the fluid metal.

According to various embodiments, the process method may be provided, wherein forming a metal inside the at least one penetration structure may comprise: forming a metal surface of an atomic unit on the inner surface of the at least one penetration structure; and growing the metal on the metal surface based on the fluid metal after the metal surface is formed.

According to various embodiments, a semiconductor packaging structure may be provided, and the semiconductor packaging structure may comprise: a substrate having at least one first interconnect structure having a conductivity formed based on a 3D printing process; and a structure having at least one second interconnect structure disposed on the substrate, wherein the at least one first interconnect structure is electrically connected to the at least one second interconnect structure, and a first density of the at least one first interconnect structure is lower than a second density of the at least one second interconnect structure.

According to various embodiments, a semiconductor packaging module may be provided, and the semiconductor packaging module may comprise: a single first semiconductor chip; and a substrate including a first surface facing a lower surface of the first semiconductor chip, a second surface facing the first surface, and at least one first interconnect structure inside between the first surface and the second surface, wherein the at least one first interconnect structure comprises a first portion exposed through the first surface, a second portion exposed through the second surface, and a line connecting between the first portion and the second portion, wherein the first portion is electrically connected to the first semiconductor chip, and the second portion is electrically connectable to another electronic component, wherein the line is transverse to the body of the single layer structure, and is formed with a specific slope in at least some sections.

According to various embodiments, an antenna packaging module may be provided, and the antenna packaging module may comprise: a substrate comprising a plurality of antennas; and a substrate comprising a first surface and a second surface having different slopes, at least one first conductive member exposed through the first surface, and at least one second conductive member exposed through the second surface, wherein the substrate is formed based on a 3D printing process, wherein the first surface and the second surface are facing different directions, and the at least one first conductive member is electrically connected to a first antenna group disposed on the first surface of the plurality of antennas, and the at least one second conductive member is electrically connected to a second antenna group disposed on the second surface of the plurality of antennas.

### 1. Customized 3D printing system

The customized 3D printing system 1 according to various embodiments is an optimized (or efficient) process based on the 3D printing technology, and may be a system implemented to produce products suitable for various types of devices (or devices) required by consumers.

For example, the customized 3D printing system 1 may be implemented to produce a packaging structure that includes an ultra-fine interconnect structure (or metal line structure, pipeline structure, or conductive member) for a semiconductor chip (e.g., processor, antenna chip, etc.). The ultra-fine interconnect structure may be formed suitable for various kinds of devices based on 3D printing. The customized 3D printing system 1 can reduce the operating burden of the packaging process for implementing high-performance semiconductors provided for each electronic device based on the 3D printing technology.

As another example, the customized 3D printing system 1 may be implemented to produce a structure that has a shape corresponding to the shape of a narrow internal space within an electronic device and provides electrical connections between other electronic components. For example, the structure for providing the electrical connection may include a socket.

In addition to the described example, the customized 3D printing system 1 may provide a service for producing products corresponding to various types of electronic devices (or various consumer demands) based on an optimal process.

Hereinafter, for convenience of explanation, a customized 3D printing system 1 that provides a production service for a packaging structure will be described as an example. However, it is apparent to those skilled in the art that the various embodiments described may be applied to the customized 3D printing system 1 for the production of other various structures.

### 2. Component of a customized 3D printing system

Hereinafter, examples of components of the aforementioned customized 3D printing system 1 according to various embodiments will be described.

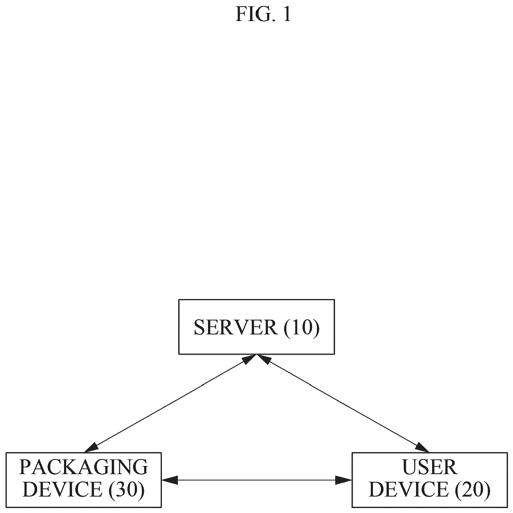

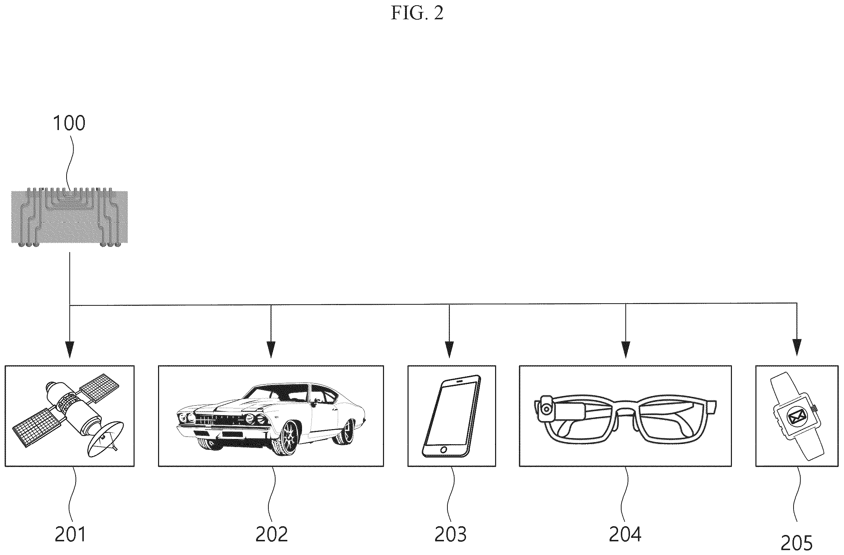

FIG. 1 is a diagram illustrating an example of a component of a customized printing system 1 according to various embodiments. Hereinafter, FIG. 1 will be further described with reference to FIG. 2.
FIG. 2 is a diagram for describing an example of an application product of a structure produced by the customized printing system 1 according to various embodiments.

According to various embodiments, referring to FIG. 1, the customized 3D printing system 1 may include a server 10, a packaging device 20, and a user device 30. Meanwhile, the customized 3D printing system 1 may be implemented to include more components and/or fewer components, without being limited to the described and/or illustrated examples. For example, the server 10 may not be implemented, and the packaging device 20 may be implemented to perform all functions of the server 10. In addition, the server 10 may be provided as an add-on type device and connected to the packaging device 20.

According to various embodiments, the server 10 is at least one electronic device of an administrator for providing a production service for a packaging structure, and may be implemented to manage the overall structure production service. For example, the server 10 may receive information from the consumer's user device 30 and/or transmit information to the user device 30. For example, the server 10 may receive a drawing file for a structure to be produced from the user device 30. In addition, the server 10 may transmit information about the structure produced by the packaging device 20 to the user device 30. In addition, the server 10 may control the packaging device 20. For example, the server 10 may convert the drawing file received from the user device 30 into a print file and control the packaging device 20 based on the print file, thereby allowing the packaging structure to be produced by the packaging device 20.

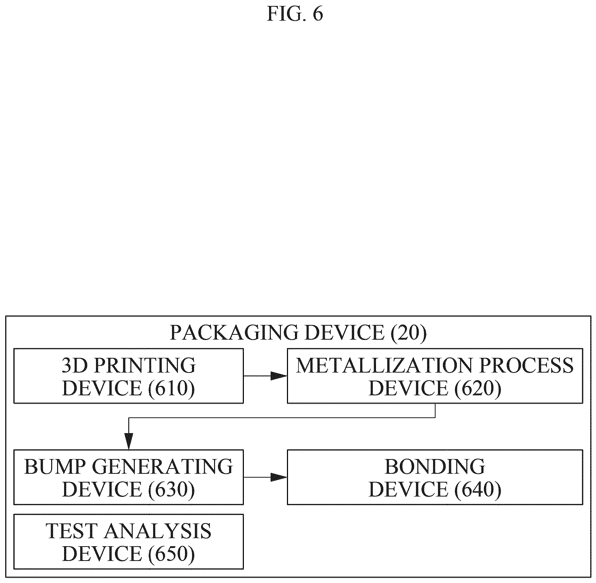

According to various embodiments, the packaging device 20 may include at least one device (or facility) for producing the packaging structure 100 including a fine interconnection structure and connecting the packaging structure to at least one semiconductor chip (or at least one electronic part), as illustrated in FIG. 2. The packaging device 20 will be described in more detail below with reference to FIGS. 6 to 7. Referring to FIG. 2, the packaging structure 100 may be implemented to be provided in various types of devices 201, 202, 203, 204, and 205 based on 3D printing technology.

According to various embodiments, the user device 30 may be a consumer's device that requests a production service for a packaging structure. The user device 30 may be various types of electronic devices available to consumers (or users), such as at least one PC, tablet, smartphone, head mounted display (HMD) device, etc. The user device 30 may acquire the drawing file generated by the consumer and transmit the drawing file to the server 10 as described above.

### 2.1 Details of each component

Hereinafter, an example of a component of the customized 3D printing system 1 according to various embodiments will be further described.

### 2.1.1 Server and user device

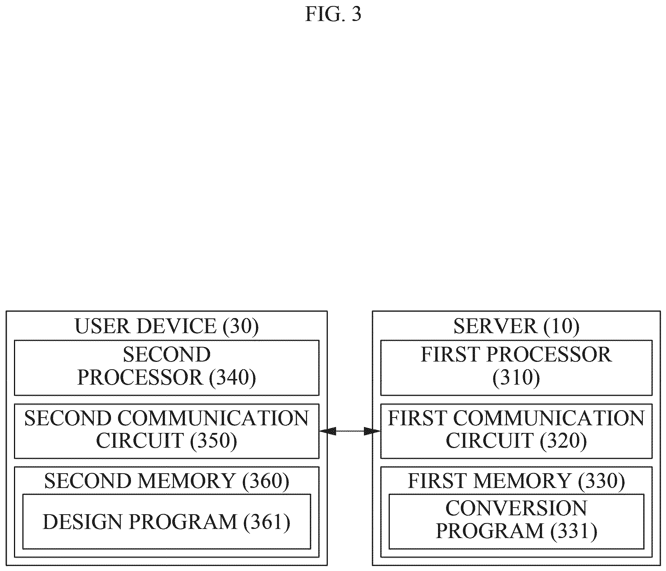

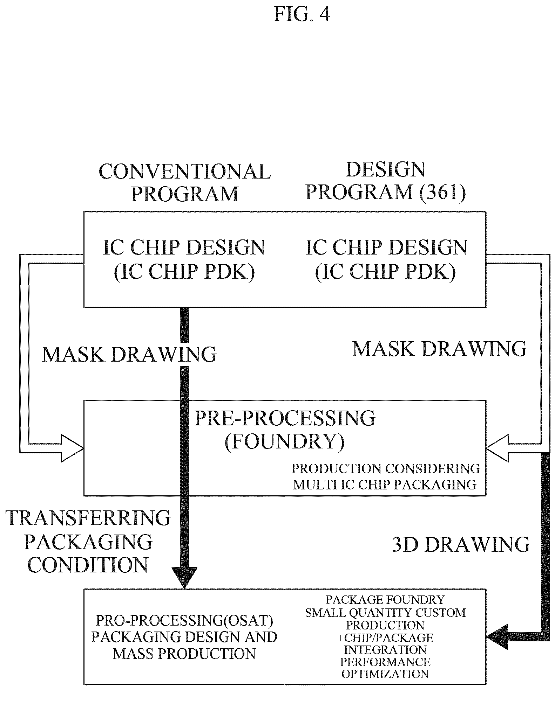

FIG. 3 is a diagram for describing the configuration of the server 10 and user device 20 according to various embodiments. Hereinafter, FIG. 3 will be described with reference to FIGS. 4 to 5.

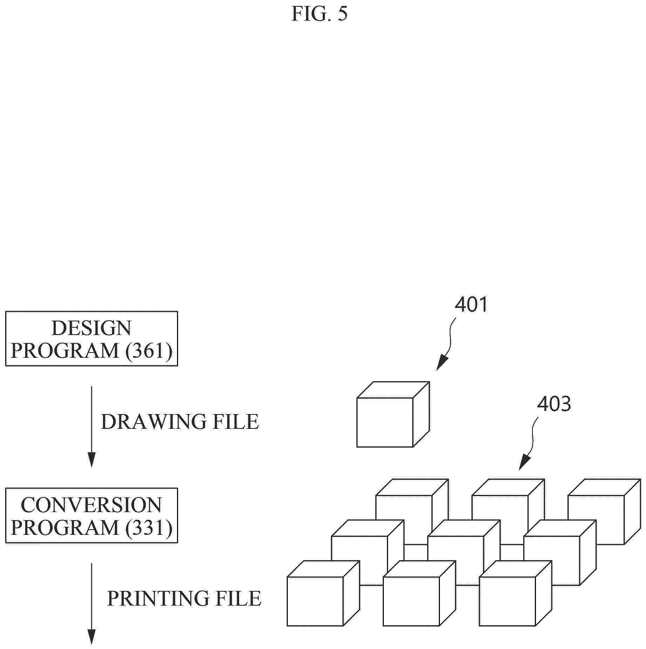

FIG. 4 is a diagram for describing an example of a design program 361 according to various embodiments. FIG. 5 is a diagram for describing an example of a conversion program 331 according to various embodiments.

According to various embodiments, referring to FIG. 3, the server 10 may include a first processor 310, a first communication circuit 320, and a first memory 330 that stores the conversion program 331, and the user device 30 may include a second processor 340, a second communication circuit 350, and a second memory 360 that stores the design program 361. Meanwhile, the server 10 and/or the user device 30 may be implemented to include more devices and/or less devices, without being limited to the described and/or illustrated examples. For example, the server 10 and/or the user device 30 may further include a speaker (not shown), a microphone (not shown), a touch screen (not shown), a display (not shown), and the like.

According to various embodiments, the first processor 310 and the second processor 340 may control at least one other component (e.g., hardware or software component) connected to the first processor 310 and the second processor 340 by executing software (or computer code, program, instructions, or module), and may be implemented to perform various data processing or calculations. According to an embodiment, as at least a part of the data processing or calculation, the first processor 310 and the second processor 340 may load a command or data received from another component into a volatile memory, process the command or data stored in the volatile memory, and store the resultant data in a non-volatile memory. According to an embodiment, the first processor 310 and the second processor 340 may include a main processor (e.g., a central processing unit or an application processor) and an auxiliary processor (e.g., a graphic processing device, an image signal processor, a sensor hub processor, or a communication processor) that is operable independently or together with the main processor. Additionally or alternatively, the auxiliary processor may be configured to use lower power than the main processor or to be specialized to a specified function. The auxiliary processor may be implemented separately from the main processor or as a part thereof.

According to various embodiments, the first communication circuit 320 and the second communication circuit 330 may support the establishment of a wireless communication channel between devices and communication performance through the established communication channel. The communication circuit (e.g., the first communication circuit 320 and/or the second communication circuit 330) may be implemented to include one or more communication processors that are operated independently from the processor (e.g., the first processor 310 and/or the second processor 340) and support wireless communication, but is not limited to the described examples.

According to various embodiments, the first memory 330 and the second memory 360 may store various data used by at least one component (e.g., the first processor 310 and the second processor 340) of the server 10 and the user device 20. For example, the first memory 330 may store the conversion program 331, and the second memory 360 may store the design program 361. Based on the execution of the programs (e.g., the conversion program 331 and the design program 361) by the above by the processor (e.g., the first processor 310 and the second processor 340), the server 10 and the user device 20 may provide functions corresponding to the program.

According to various embodiments, the design program 361 may be implemented to generate drawing files for the packaging structure. As an example, the drawing file may be a cad file including the design of the packaging structure, but is not limited to the examples described, and may have various types of formats for including the design of a three-dimensional structure for the design of the structure. For example, as shown in FIG. 4, the design program 361 may be implemented to provide a function so that both the design of the chip and the design of the package are possible. For example, in the related art, as the chip design program for designing the chip and the package design program for designing the package are separately implemented, each of the chip and the package may not be designed in a form considering each other, resulting in a resource burden for the design. The design program 361 according to various embodiments may be implemented to provide an integrated interface for the integrated design of the chip and the packaging structure, an integrated rule (or integrated parameter) for the design of the chip and the package, and an integrated tool. The integrated interface may mean a graphic user interface for the integrated tool (e.g., drawing tool or the like) consumer (or user) to drawing the chip and the package. The integrated rule (or integrated parameter) may mean physical characteristics, material characteristics, and electrical characteristics such as size, and the like, which are applied to the chip and the packaging designed based on the design program 361. For example, the design program 361 may be implemented to generate a mask drawing file for the chip and a 3D drawing file for the packaging structure. The consumer may be able to design the chip and the packaging structure corresponding to the chip on the integrated interface based on the integrated rule by using the design program installed in the user device 30. Accordingly, as the design of each of the chip and the package may be considered each other, the resources for the design are reduced, and the connectivity (e.g., electrical connectivity, physical connectivity) between the produced chip and the produced packaging structure may be improved, so that high-quality semiconductor packaging may be performed.

According to various embodiments, the conversion program 331 may be implemented to generate a print file corresponding to the drawing file. As an example, the print file may be a STL file including the design of the packaging structure, but is not limited to the examples described, and may be a file having various types of formats for 3D printing. Based on the print file, the packaging device 20 described below may produce the packaging structure. Referring to FIG. 5, according to an embodiment, the conversion program 331 may be implemented to generate a print file including a plurality of packaging structures 403 based on the packaging structure 401 included in the drawing file. At this time, the conversion program 331 may be implemented to determine the number of the plurality of packaging structures included in the print file based on the number of the packaging structures required by the consumer. Accordingly, the productivity of the packaging structure 100 produced when the process is performed in the process of the packaging device 20 is improved, and accordingly, the process operation burden may be reduced by performing an optimal process in the consumer's production demand.

According to various embodiments, the conversion program 331 may generate a print file corresponding to the packaging structure including at least one through structure (or a a hole structure). That is, the conversion program 331 may generate a print file for the outer appearance of the structure except the interconnect of the interconnect of the metal material. This may be implemented by the 3D printing device 610 to determine the number of the plurality of packaging structures included in the

On the other hand, the aforementioned conversion program 331 is not limited to the described and/or illustrated example, and the customized 3D printing system 1 may be implemented in a form in which the print file stored in the user device 30 and converted by the user device 30 is provided to the server 10, or the design program 361 is authored to the server 10 and the user device 30 is connected to the server 10 to use the design program 361.

### 2.1.1 Packaging device

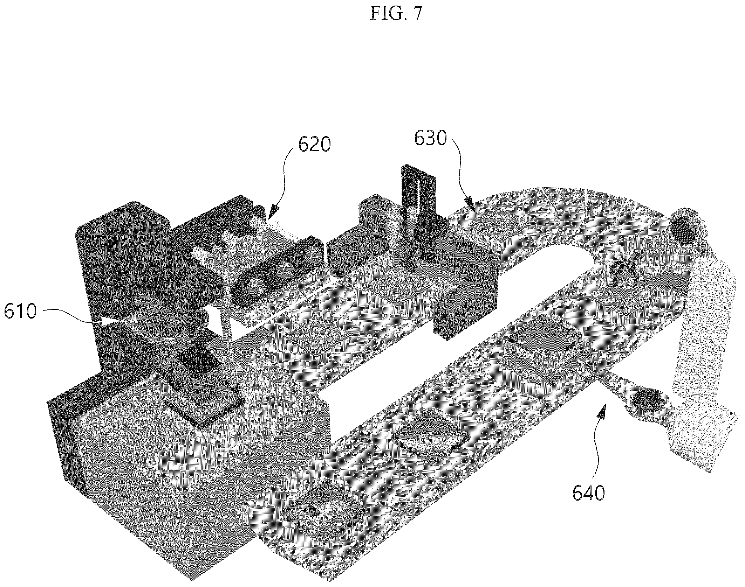

FIG. 6 is a diagram for describing an example of a configuration of the packaging device 20 according to various embodiments. Hereinafter, FIG. 6 will be further described with reference to FIG. 7.

FIG. 7 is a diagram for describing an example of an implementation of the packaging device 20 according to various embodiments.

According to various embodiments, referring to FIG. 6, the packaging device 20 may include a printing device 610, a metallization process device 620, a bump generating device 630, a bonding device 640, and a test analysis device 650 to generate a packaging structure. Referring to FIG. 7, the aforementioned devices (or facilities) of the packaging device 20 may be provided in a form capable of a continuous process. For example, each device may be implemented in a form of being connected for a process based on at least one trailer, and the process for a packaging structure moving on the trailer may be performed by the aforementioned devices 610, 620, 630, 640, and 650. The packaging structure may mean at least one of a substrate (or dielectric layer) generated by the printing device 610, a substrate including an interconnect generated by the metallization process device 620, a substrate where a bump is formed by the bump generating device 630, or a structure including another electronic component (e.g., a chip and/or a packaging substrate) and a substrate physically connected to another electronic component by the bonding device 640. On the other hand, the packaging device 20 may be implemented to include more devices (or facilities) or fewer devices (or facilities), without being limited to the described and/or illustrated examples. For example, the packaging device 20 may be implemented to include only the 3D printing device 610 and the metallization process device 620 to generate a structure (or substrate) including various types of fine interconnects, but is not limited to the described examples.

According to various embodiments, the 3D printing device 610 may be implemented to form a substrate including at least one empty space structure (or hole structure) based on the 3D printing process and the print file. The 3D printing apparatus may be implemented as a device that performs a 3D printing process based on at least one of a material extrusion type method such as fused deposition modeling (FDM) and fused filament fabrication (FFF), a photopolymerization type method such as stereolithography (SLA), digital light processing (DLP), continuous liquid interface production technology (CLIP), liquid crystal display (LCD), and projection micro streolithopraphy (PuSL), a powder sintering method such as stereolithography (SLS), selective laser melting (SLM), direct metal laser sintering (DMLS), and multi-jet printing (MJP), a binder spraying method such as color jet printer (CJP), and inkjet printer (IJP), a sheet amination method such as laminated object manufacturing (LOM), selective deposition lamination (SDL), and viscous lithography manufacturing (VLM), or a directional energy deposition method such as laser-aided direct metal tooling (DMT), laser metal deposition (LMD), and laser engineered net shaping (LENS), and the like, and the 3D printing method is well-known and thus a detailed description thereof will be omitted. Accordingly, the material of the substrate generated by the 3D printing apparatus 610 may be selected as at least one of a light (e.g., ultraviolet, infrared, visible light) curable material or a thermally curable material based on the 3D printing method described above.

According to various embodiments, the 3D printing apparatus 610 may be implemented to generate the substrate at a resolution (or resolution) in µm. The resolution may include 2µm, 10µm, and 25µm, but is not limited to the described example.

According to various embodiments, the metallization process apparatus 620 may be implemented to generate at least one interconnect (or at least one metal line) inside the substrate generated by the 3D printing apparatus 610. For example, as shown in FIG. 7, the metallization process apparatus 620 may fill and grow a conductive material (e.g., metal) in at least one through structure inside the substrate (or may fill with a metal).

According to various embodiments, the bump generation apparatus 630 may generate a bump for electrically connecting to other electronic components (e.g., chips, packaging substrates, and the like) on the surface of the substrate. The bump may include at least one of a pillar of copper material and a bump of lead material (Cu pillar+Solder bump) disposed on the pillar, a bump of stud-shaped lead material, or a bump of ball-shaped lead material, but is not limited to the described example, and the bump may be formed in various materials and in various shapes, and a detailed description thereof will be omitted because of well-known techniques. Meanwhile, before forming the bump, the bump generation apparatus 630 may form under bump metallurgy (UBM) in a portion where the interconnect is exposed.

According to various embodiments, the bonding apparatus 640 may physically connect other electronic components (e.g., chips, packaging substrates, and the like) with the substrate where the bump is generated, and a detailed description thereof will be omitted because of well-known techniques.

According to various embodiments, the test analysis apparatus 650 may be implemented to perform test analysis on the packaging structure generated by the packaging apparatus 20. The type of test analysis may include electromagnetic simulation, thermal durability, pulse response, optical non-destructive testing, etc., and test analysis for detecting defects between processes.

### 3. Process

Hereinafter, an example of the process based on the packaging device 20 according to various embodiments will be described.

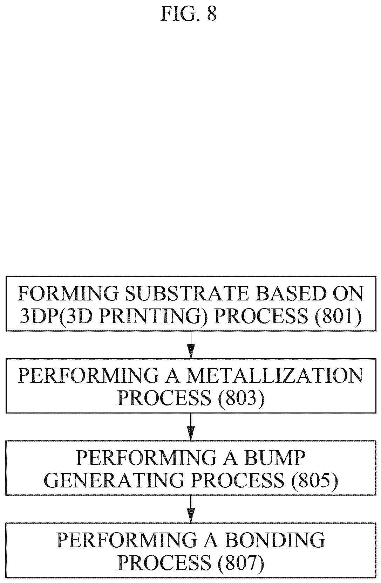

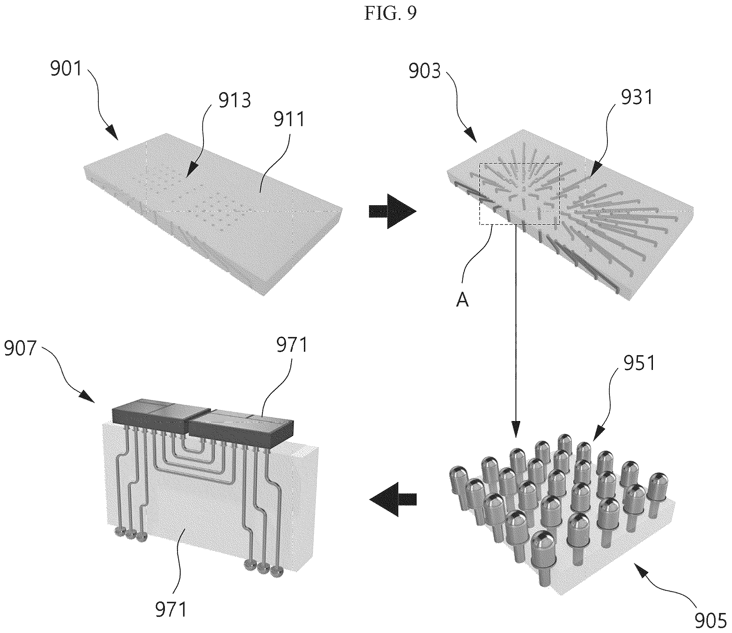

FIG. 8 is a flowchart illustrating an example of a process according to various embodiments. Operations may be performed regardless of the order of the operations shown and/or described, and more operations may be performed and/or fewer operations may be performed. Hereinafter, FIG. 8 will be further described with reference to FIG. 9.

FIG. 9 is a diagram for describing an example of a substrate formation process, a metallization process, a bump formation process, and a bonding process according to various embodiments.

According to various embodiments, the packaging device 20 (e.g., the 3D printing device 610) may form a 3DP(3D printing) based substrate in operation 801. For example, the packaging device 20 may form a substrate including at least one internal structure based on the 3DP. For example, the at least one internal structure may include a penetration structure. As shown in 901 of FIG. 9, the packaging device 20 (e.g., the 3D printing device 610) may generate a substrate 911 having at least one penetration structure 913 formed inside a printed file based on the 3D printing. At this time, as the substrate 911 is formed in a shape suitable for consumer demand (or suitable for various kinds of electronic devices) based on the 3DP, the space inside the electronic device may be optimized, and the quality of the form factor of the electronic device may be improved.

For example, the packaging device 20 may form a substrate including at least one external structure based on the 3DP.

According to various embodiments, the packaging device 20 (e.g., the metallization process device 620) may perform a metallization process in operation 803. For example, as shown in 903 of FIG. 9, the packaging device 20 (e.g., the metallization process device 620) may metalize the at least one penetration structure 913 inside the substrate 911, thereby forming at least one interconnect 931 (or metal line) inside the substrate 911.

According to various embodiments, the packaging device 20 (e.g., the bump generating device 630) may perform the bump generating process in operation 805. For example, as shown in 905 of FIG. 9, the packaging device 20 (e.g., the bump generating device 630) may form a bump 951 on the substrate 911. Each bump 951 may be formed on a portion of the at least one interconnect 931 exposed to the outer surface of the substrate 911, and may be electrically connected.

According to various embodiments, the packaging device 20 (e.g., the bonding device 640) may perform the bonding process in operation 807. For example, as shown in 907 of FIG. 9, the packaging device 20 (e.g., the bonding device 640) may physically connect at least one electronic component (e.g., a chip) 973) different from the bump 951 formed on the substrate 911, and may electrically connect the at least one electronic component (e.g., a chip) 973) different from the substrate 911. Electrical connections may be established between electronic components that are physically (or electrically) connected to the substrate 911 based on at least one connector 931 formed inside the substrate 911. In this case, since the interconnect 931 may be implemented in various forms by the above-described 3DP substrate forming process 801, the interconnect 931 may be formed with a simpler and more efficient electrical connection structure without a complicated electrical connection structure compared to conventional packaging members (e.g., redistribution layer (RDL) and through silicon via (TSV)), thereby improving product quality and reducing electrical energy loss.

According to various embodiments, the semiconductor packaging process may be simplified based on the above-described processes 801, 803, 805, and 807. For example, a process for forming the existing interconnect structure (e.g., redistribution layer (RDL) and through silicon via (TSV)) may include forming a dielectric layer (e.g., substrate), forming a photomask process (hole forming process), filling a conductive material, forming a metal seed layer, forming a photoresist, forming a rewiring layer, and etching. The packaging device 20 according to various embodiments may reduce the process steps and efficient the packaging process by performing only a single process for forming the 3DP-based substrate 801 instead of a multi-step process for forming a hole based on the photomask after forming the dielectric layer. In addition, the packaging device 20 may reduce the process steps and efficient the packaging process by performing a microfluidic metal-based metallization process on the substrate 801 having the penetration structure instead of a multi-step process including forming a metal seed layer, forming a photoresist, forming a rewiring layer, and etching.

Hereinafter, examples of each process according to various embodiments will be described in detail.

### 3.1 3DP-based substrate forming process

### 3.1.1 Substrate forming process and material of the substrate

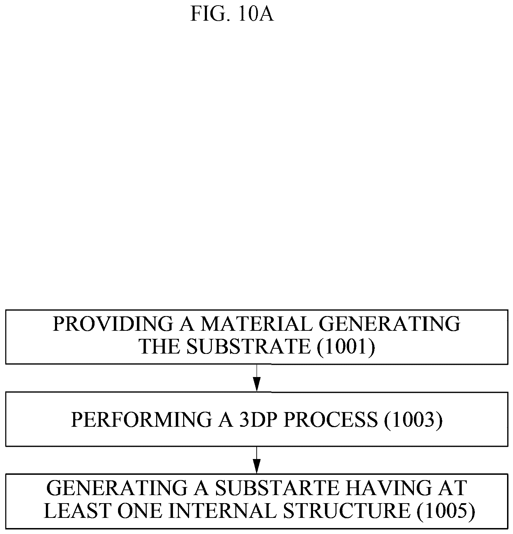

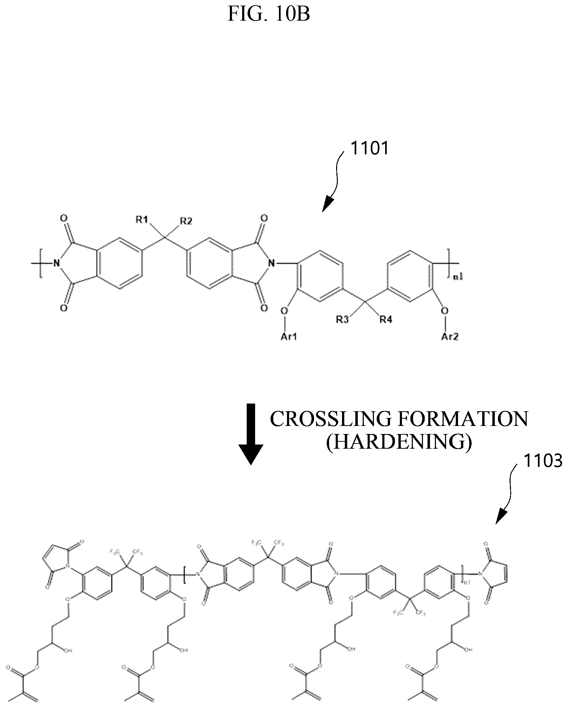

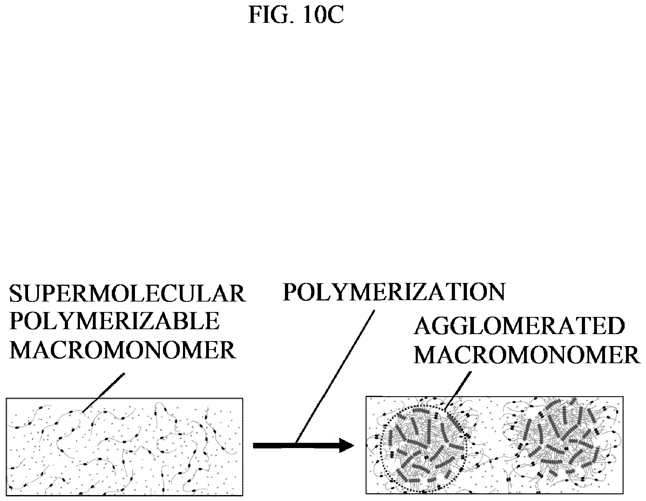

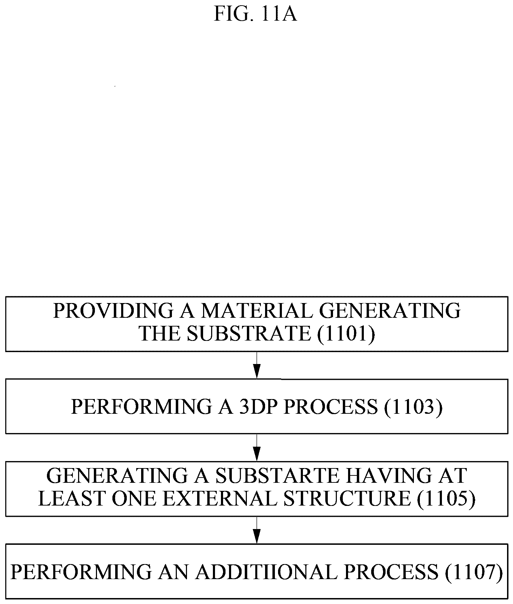

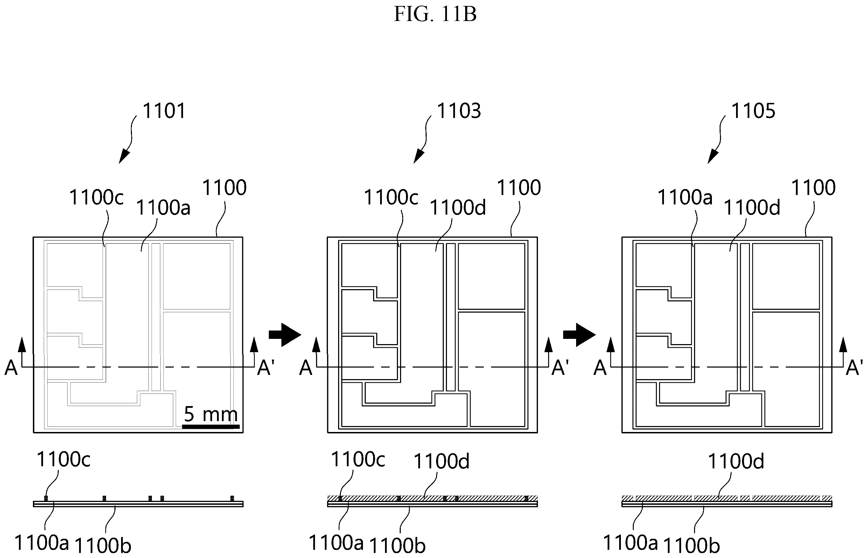

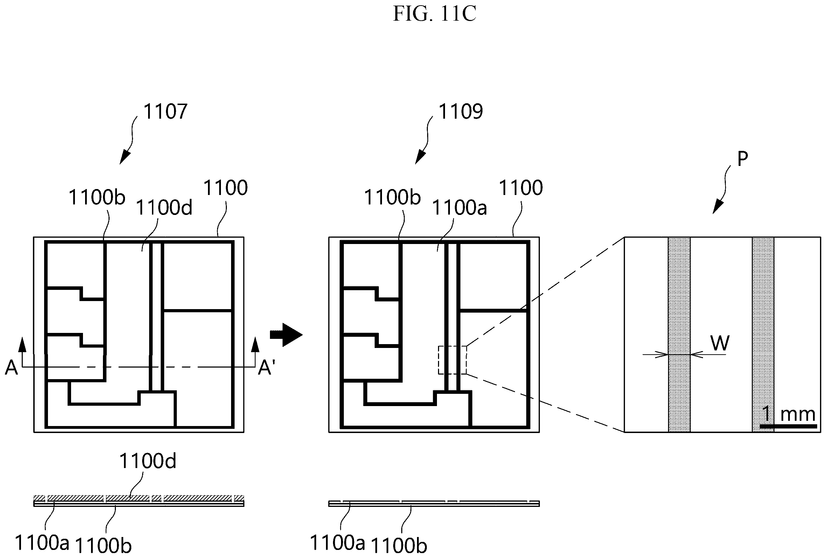

FIG. 10A is a flowchart illustrating an example of a 3DP-based substrate 911 forming process according to various embodiments. Operations may be performed regardless of the order of the operations shown and/or described, and more operations may be performed and/or fewer operations may be performed. Hereinafter, FIG. 10 will be further described with reference to FIG. 11.

FIG. 10B is a diagram for describing an example of a material of a substrate including Chemical Formula 1 according to various embodiments. FIG. 10C is a diagram for describing an example of a material of a substrate including Chemical Formula 2 according to various embodiments.

According to various embodiments, the packaging device 20 (e.g., the 3D printing device 610) may provide a material for generating the substrate 911 (or dielectric layer) in operation 1001.

According to various embodiments, the material can be a material having at least one of characteristics that can be processed based on 3D printing or characteristics for semiconductor packaging. Material may be implemented to have at least one of processable characteristics or characteristics for semiconductor packaging, described by way of example below.

For example, as the processable characteristic, the material may have characteristics that can be cured based on the above-described various types of 3D printing schemes. For example, the material may have thermal curing and/or photocuring characteristics.

Hereinafter, the material will be described in more detail.

According to various embodiments, the term "substituted" means that a hydrogen atom bonded to a carbon atom of a compound is changed into another substituent, and the substituted position is not limited as long as it is a position at which a hydrogen atom is substituted, that is, a position at which a substituent is substituted, and when two or more substituents are substituted, two or more substituents may be the same as or different from each other.

In the present specification, "substituted or unsubstituted" means that it is unsubstituted or substituted with one or more substituents selected from the group consisting of deuterium; a halogen group; a cyano group; a C1 to C60 alkyl group; a C2 to C60 alkenyl group; a C2 to C60 alkynyl group; a C3 to C60 cycloalkyl group; a C2 to C60 heterocycloalkyl group; a C6 to C60 aryl group; a C2 to C60 heteroaryl group; a silyl group; a phosphine oxide group; and an amine group, or a substituent linked to two or more substituents selected from the among the exemplified substituents.

### 3.1.1.1 first composition or a cured product thereof

According to various embodiments, the substrate material includes a first composition including an oligomer including a monomer represented by the following Chemical Formula 1; a compound including at least two acrylate functional groups; and a photoinitiator; or a cured product thereof.

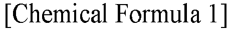

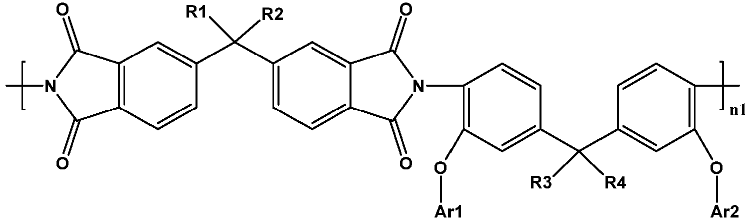

In this case, the first composition may be directly or may include a cured product thereof, and the cured product of the first composition may be a photosensitive polyimide photocurable resin.

According to various embodiments, R1 to R4 may be the same as or different from each other, and may each independently be a substituted or unsubstituted C1 to C40 alkyl group.

According to various embodiments, R1 to R4 may be the same as or different from each other, and may each independently be a substituted or unsubstituted C1 to C30 alkyl group.

According to various embodiments, R1 to R4 may be the same as or different from each other, and may each independently be a substituted or unsubstituted C1 to C10 alkyl group.

According to various embodiments, R1 to R4 may be the same as or different from each other, and may each independently be a substituted or unsubstituted C1 to C10 alkyl group.

According to various embodiments, R1 to R4 may be the same as or different from each other, and may each independently be a substituted or unsubstituted C1 to C10 alkyl group.

According to various embodiments, R1 to R4 may be the same as or different from each other, and may each independently be a trifluoromethyl group. According to various embodiments, R1 to R4 may be the same.

According to various embodiments, Ar1 and Ar2 may be the same as or different from each other, and may each independently be a substituent including a (meth)acrylate functional group.

In the present specification, the (meth)acrylate includes both acrylate and methacrylate. The (meth)acrylate-based resin may be, for example, a copolymer of a (meth)acrylic acid ester-based monomer and a crosslinkable functional group-containing monomer.

According to various embodiments, Ar1 and Ar2 are the same as or different from each other, and are each independently a substituent including a (meth)acrylate functional group, and may be represented by the following structural formula.

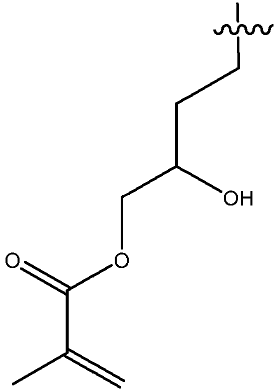

In the structural formula, 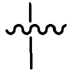 means a position linked to a monomer.

According to various embodiments, the oligomer including the monomer represented by Chemical Formula 1 has a structure in which most of the structure is formed of a polyimide component known to have a low dielectric constant and a low CTE, and thus the oligomer may have a desired dielectric constant value and a CTE value, and has a structure in which the number of (meth)acrylate functional groups per unit volume is very large, and when the (meth)acrylate functional groups are sensitive to light, the oligomer may be interconnected to form a very dense polymer network, and thus the structure may have a characteristic in which the expansion rate due to heat is lowered, and thus the oligomer may have a low CTE value.

In addition, the oligomer including the monomer represented by Chemical Formula 1 has a structure in which the number of methacrylate functional groups per unit volume is very large, and thus the free volume which is not sensitive to light is extremely small, and thus the oligomer may achieve a very high resolution (10 µm or less) required in semiconductor packaging.

In various embodiments, the compound including at least two acrylate functional groups may be trimethylolpropane triacrylate.

The compound including the at least two acrylate functional groups assists the connectivity between the monomers of Formula 1 to be further deepened, thus enabling low CTE values, and assists the monomers of Formula 1 in a solid state to be dissolved in a solution state capable of 3D printing.

In various embodiments, the photoinitiator may be substituted with one or two or more substituents selected from the group consisting of a triazine-based compound, a biimidazole compound, an acetophenone-based compound, an O-acyloxime-based compound, a thioxanthone-based compound, a phosphine oxide-based compound, a coumarin-based compound, and a benzophenone-based compound.

Specifically, the photoinitiator may be a triazine-based compound such as 2,4-trichloromethyl-(4'-methoxyphenyl)-6-triazine, 2,4-trichloromethyl-(4'-methoxystyryl)-6-triazine, 2,4-trichloromethyl-(picolinyl)-6-triazine, 2,4-trichloromethyl-(3'-(4'-dimethoxyphenyl)-6-triazine, 3-{4-[2,4-bis(trichloromethyl)-s-triazine-6-yl]phenylthio}propanoic acid, 2,4-trichloromethyl-(4'-ethylbiphenyl)-6-triazine, or 2,4-trichloromethyl-(4'-methylbiphenyl)-6-triazine; a biimidazole-based compound such as 2,2'-bis(2-chlorophenyl)-4,4',5,5'-tetraphenyl biimidazole or 2,2'-bis(2,3-dichlorophenyl)-4,4',5,5'-tetraphenyl biimidazole; an acetophenone-based compound such as 2-hydroxy-2-methyl-1-phenylpropan-1-one, 1-(4-isopropylphenyl)-2-hydroxy-2-methylpropan-1-one, 4-(2-hydroxyethoxy)-phenyl(2-hydroxy)propyl ketone, 1-hydroxcyclohexyl phenyl ketone, 2,2-dimethoxy-2-phenyl acetophenone, 2-methyl-(4-methylthiophen-2-yl)-2-morpholino-1-propan-1-one (Irgacure-907), or 2-benzyl-2-dimethylamino-1-(4-morpholinophenyl)-butan-1-one (Irgacure-369); an O-acyloxime-based compound such as Irgacure OXE 01, Irgacure OXE 02 from Ciba Geigy Co; 4,4'-bis(dimethylamino)benzophenone or 4,4'-bis(diethylamino)benzophenone; the thioxanthone-based compound such as 2,4-diethyl thioxanthone, 2-chloro thioxanthone, isopropyl thioxanthone or diisopropyl thioxanthone; the phosphine oxide-based compound such as 2,4,6-trimethylbenzoyl diphenylphosphine oxide, bis(2,6-dimethoxybenzoyl)-2,4,4-trimethylpentyl phosphine oxide or bis(2,6-dichlorobenzoyl) propyl phosphine oxide; the coumarin-based compound such as 3,3'-carbonylvinyl-7-(dimethylamino)coumarin, 3-(2-benzothiazolyl)-7-(dimethylamino)coumarin, 3-benzoyl-7-(dimethylamino)coumarin, 3-benzoyl-7-methoxy-coumarin or 10,10'-carbonylbis[1,1,7,7-tetramethyl-2,3,6,7-tetrahydro-1H,5H,11H-Cl]-benzopyrano[6,7,8-ij]-quinolizin-11-one may be used alone or in combination with two or more thereof, but the present invention is not limited thereto.

Specifically, the photoinitiator may be 2-hydroxy-2-methylpropiophenone.

In various embodiments, the weight ratio of the oligomer including the monomer represented by Chemical Formula 1 to the compound including at least two acrylate functional groups may satisfy a ratio of 40:30 to 75: 10, specifically 50:50 to 65:5.

The CTE and the dielectric constant of the substrate including the above-described ranges are appropriate and may have a resolution in units of um according to the 3D printing process.

In this case, the cured product of the first composition may have a dielectric constant of 2.5 to 3.0, a coefficient of thermal expansion (CTE) of 10 ppm K-1 or more and 20 ppm K-1, and may have a resolution in units of um according to the 3D printing process.

Hereinafter, a preparation example in which a photosensitive polyimide photocurable resin is prepared by curing a first composition is described.

### <preparation example>

### 1) Preparation of an oligomer including a monomer represented by Chemical Formula 1.

To 4 g of 2,2'-bis(3-amino-4-hydroxyphenyl) hexafluoropropane dissolved in 25 mL of methylpyrrolidone, 4.041 g of 2,2'-bis(3,4-dicarboxy-phenyl) hexafluoropropane dianhydride was added gradually at 0° C under an argon atmosphere.

The mixture was stirred at 0° C for 6 hours, and 0.357 g of maleic anhydride was added thereto, and the mixture was further stirred for 1 hour to obtain a pale brown solution.

The temperature was raised to 60° C for 2 hours, and then again raised to 110° C for 2 hours, and finally raised to 205° C for 4 hours to form a polyimide oligomer.

After cooling to 30° C., 3.093 g of glycidyl methacrylate, 30 mg of triethylamine, 50 mg of tetraethylammonium bromide, and 50 mg of hydroquinone were added to the obtained solution, and the mixture was stirred at 100° C for 4 hours.

After cooling to room temperature, the solution was poured into 100 mL of distilled water to precipitate. The precipitated powder was filtered, and dried in a vacuum state at 40° C for 12 hours or more to obtain an oligomer including a monomer represented by Chemical Formula 1.

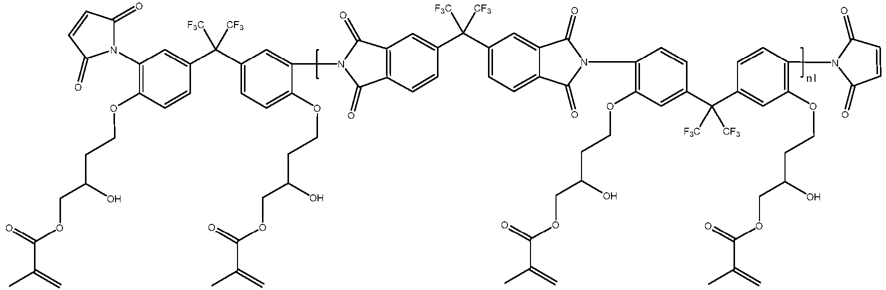

### 2) preparation of a photocurable resin according to curing

The oligomer containing the monomer represented by Chemical Formula 1 prepared above, trimethylolpropane triacrylate, and methylpyrrolidone were mixed at a weight ratio of 60:10:30, and then 2-hydroxy-2-methylpropiophenone was added at a weight ratio of 2 of the mixture.

Here, the weight ratio of monomer A and monomer B may be 50:50 to 65:5.

### 3.1.1.2 Second composition or a cured product thereof.

According to various embodiments, a material for a substrate for electrical connection between electronic components is provided, further comprising a second composition comprising an oligomer comprising a monomer represented by the following Chemical Formula 2; a compound comprising at least two acrylate functional groups; and a photoinitiator; or a cured product thereof.

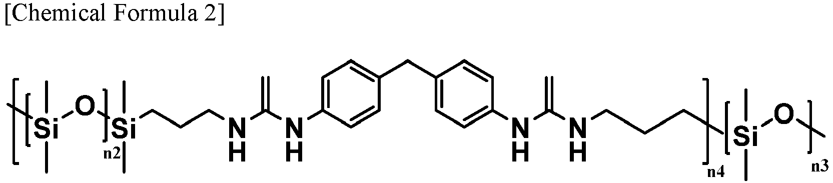

In various embodiments, the oligomer including the monomer represented by Chemical Formula 2 may be the following structural formula.

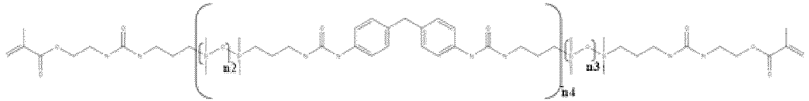

In the structural formula, the definitions of n2 to n4 are the same as those in Chemical Formula 2.

When the second composition of the present application is cured, the cured product may be a POSS photocurable resin including a supermolecular polymerizable crosslinking agent.

In the case of the substrate according to the present application, the substrate may include the second composition together with the aforementioned first composition.

In this case, as can be seen from FIG. 10C, supermolecular polymerization occurs between the 4,4'-methylene diphenyl diurea functional group included in the monomer represented by Chemical Formula 2, thereby allowing the methacrylate functional group located at the end of the monomer represented by Chemical Formula 2 to be aggregated at a high density.

Due to the effect of the aggregated methacrylate functional group, the photocurable resin including Chemical Formula 2 may be 3D printed at a high resolution, and accordingly, achieves a very high resolution (10 µm or less) required in semiconductor packaging.

In addition, due to the effect of the aggregated methacrylate functional group, the network between the monomers of Chemical Formula 2 after photosensitization is induced to have a dense structure, thereby having a low CTE and a low dielectric loss.

In various embodiments, the compound including at least two acrylate functional groups may be POSS acrylate and may be expressed by the following structural formula.

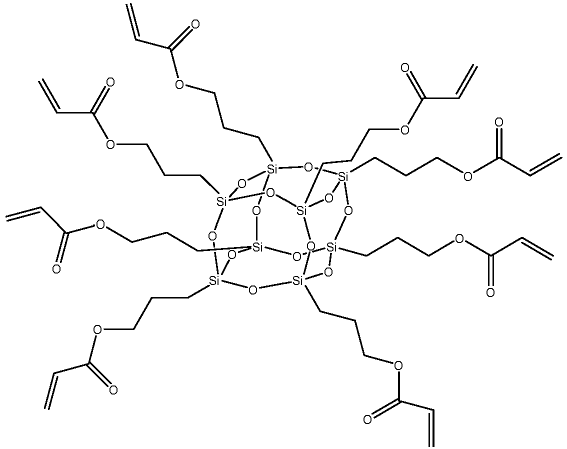

As described above, the second composition may include POSS acrylate and, when the second composition includes POSS acrylate, the second composition may include a silica (SiO2) component known to have a low dielectric constant and a low CTE, thereby allowing the second composition to have a desired dielectric constant value and a CTE value.

The photoinitiator included in the second composition may be applied as the description of the photoinitiator included in the first composition described above.

In various embodiments, the weight ratio of the oligomer including the monomer represented by Formula 2 to the compound including at least two acrylate functional groups may be 60:40 to 60:40, and specifically, 50:50 to 60:40.

In various embodiments, the cured product of the second composition may have a dielectric constant of 3.3 to 3.6, a coefficient of thermal expansion (CTE) of 5 ppm K-1 to 10 ppm K-1, and a resolution of um according to a 3D printing process.

In various embodiments, the substrate material may include the cured product of the first composition (photosensitive polyimide photocurable resin) and the cured product of the second composition (POSS photocurable resin including a supermolecular polymerizable crosslinking agent) simultaneously, and in this case, the weight ratio of the two cured products may be 60:40 to 60:40.

Hereinafter, a preparation example in which a photosensitive polyimide photocurable resin is prepared by curing a second composition is described.

### <preparation example>

### 1) Preparation of an oligomer including a monomer represented by Chemical Formula 2

To a flask containing 10 g of aminopropyl-terminated polydimethylsiloxane, 50 mL of chloroform was added, and 0.7 mL of triethylamine was added.

0.375 g of 4,4'-methylene diphenyl diisocyanate was dissolved in 15 mL of chloroform, and the solution was dropped into a flask by one drop at room temperature over 90 minutes, so that 4,4'-methylene diphenyl diurea functional group was formed between the polydimethylsiloxane polymers.

At this time, the reaction was carried out under an argon atmosphere without moisture.

Next, 1.1 mL of methacryloyloxyethyl isocyanate was added to the reaction solution, and then the reaction was carried out at room temperature for 2 hours to bind to both ends of the monomers.

Next, 500 mL of methanol was added to the finished solution, and a suspension solution was discarded, and the precipitated solid material was dried at room temperature, thereby obtaining an oligomer including the monomer of Formula 2.

### 2) preparation of photocurable resin

The oligomer including the monomer of Chemical Formula 2 and the POSS acrylate compound were mixed at a weight ratio of 10:90 and then 2-hydroxy-2-methylpropiophenone was added as much as 2 weight ratio of the mixture.

At this time, tetrahydrofuran may be added at a weight ratio of 0 or more and less than 50 weight ratio of the mixture to control the viscosity of the photocurable resin.

As characteristics for the semiconductor packaging, the material may have characteristics (or characteristics capable of curing) capable of performing a process in units of µm based on the semiconductor packaging. In other words, the material may have a resolution in units of µm. The unit of µm may include a range of 2 µm or more and 25 µm or less, and may preferably be 2 µm, 10 µm, and 25 µm. Accordingly, the material may be formed in units of µm having a width of a through structure formed in the substrate 911, and a width of an interconnect (or a metal line) formed by a metallization process may be formed in units of µm, thereby providing an optimal electrical connection between electronic components (e.g., chips).

Meanwhile, the material is not limited to the described example, and as characteristics for the semiconductor packaging, the material may be implemented to have characteristics capable of performing a process in units of nm. In other words, the material may have a resolution in units of nm.

For example, as characteristics for the semiconductor packaging, the material may have dielectric constant characteristics as shown in Table 1 below depending on a type of an electronic product (e.g., a substrate) provided (or physically connected) with the substrate 911 after being cured based on a 3D printing process, but is not limited to the described example, and may be implemented to have dielectric constants exceeding the described range depending on the type of the product.

**<Table 1>**

| Type of Substrate | Dielectric constant |
|---|---|
| Normal substrate (or chip-let package substrate) | In the range of 2.4 GHz to 3.6 GHz, less than or equal to 3.9, or preferably, less than or equal to 3.3 in 3 GHz. |
| Substrate for antenna having coaxial structure | In the range of 2.4 GHz to 3.6 GHz, 4.9 or less, or preferably 3.9 or less in the range of 3 GHz. |

Accordingly, the loss rate of the electrical connection signal through the interconnect may be reduced. In addition, for example, as a characteristic for the semiconductor packaging, the material may be implemented to have a loss tangent of 0.01 or less after being cured based on the 3D printing process, but is not limited to the described example, and may be implemented to have a loss tangent that exceeds the range described according to the type of product, such as the dielectric constant described above.

In addition, for example, as a characteristic for the semiconductor packaging, the material may be implemented to have a roughness of 0.7 µm or less, or preferably 0.5 µm or less after being cured based on the 3D printing process, but is not limited to the described example, and may be implemented to have a roughness that exceeds the range described according to the type of product described above. Accordingly, the roughness of the inner surface of the through structure (e.g., hole) formed inside the substrate 911 may be implemented to be 0.7 µm or less, or preferably 0.5 µm or less, as described above. As the roughness of the inner surface of the through structure is implemented to the above range, the growth of metal based on the metallization process may be smoothed, and electrical connectivity may be improved. In addition, for example, as a characteristic for the semiconductor packaging, the thermal expansion coefficient may be 41 ppm/°C or less, or preferably 35 ppm/°C or less, but is not limited to the described example, and may be implemented to have a thermal expansion coefficient that exceeds the range described according to the type of product. As the substrate 911 is implemented to have the thermal expansion coefficient in the above range, even if heat is applied to the electronic products provided with the substrate 911, the strain rate due to heat may be limited, and physical connection quality with other electronic products (e.g., substrates and chips) physically connected to the substrate 911 may be improved.

According to various embodiments, the material may be implemented to include at least one monomer, as illustrated in FIG. 10B. The at least one monomer may be implemented to have a characteristic of being cured based on the above 3DP methods. Meanwhile, the material may be a material such as glass, ceramic, or plastic, but is not limited to the illustrated and/or described example.

According to various embodiments, the packaging device 20 (e.g., the 3D printing device 610) may perform 3D printing process in operation 1003, and generate a substrate having at least one internal structure (e.g., a through structure) in operation 1005. For example, the 3D printing may include light curing and thermal curing. Preferably, the 3D printing may be performed based on UV. In this case, after forming the substrate based on UV having a first intensity, a processing process for removing a material remaining on the substrate based on UV having a second intensity higher than the first intensity may be continuously performed. For example, when the 3D printing method is the PuSL method, the packaging device 20 (e.g., the 3D printing device 610) may cure the material in a layer unit with precision at the CNC level, and generate the substrate 911 (or a dielectric layer) having at least one through structure as a result of the process.

According to various embodiments, the unit of the width of the at least one internal structure (e.g., the through structure) may be in µm.

According to various embodiments, the aspect ratio of the at least one internal structure (e.g., the through structure) may be 10 or more, but is not limited to the described example.

According to various embodiments, the packaging device 20 (e.g., the 3D printing device 610) may generate at least one structure formed at a position different from a position where the penetration structure is formed, in addition to the penetration structure described above, as at least a part of an operation of generating at least one internal structure. For example, the packaging device 20 (e.g., the 3D printing device 610) may form various empty spaces in the interior of the substrate 911. The empty space may be formed at a location different from the location where the at least one penetration structure is formed to improve the heat dissipation performance generated from the substrate 911 and/or reduce the physical stress applied to the substrate 911. In addition, for example, the packaging device 20 (e.g., the 3D printing device 610) may generate a water passage structure. Through the water passage structure, a fluid may be provided to discharge waste heat of the substrate 911. In addition, for example, the packaging device (e.g., the 3D printing device 610) may implement the substrate 911 so as to include a structure or a configuration for providing functions of various components that may be implemented around a conventional semiconductor package in addition to the above-described structures. As the configuration and/or the structure implementing various functions in the substrate 911 are directly formed, the size of the packaging structure may be reduced, enabling a more efficient implementation of electronic products.

### 3.1.2 Substrate external structure formation process

FIG. 11A is a flowchart illustrating an example of a 3DP-based substrate 911 formation process according to various embodiments. Operations may be performed regardless of the order of the operations shown and/or described, and more operations may be performed and/or fewer operations may be performed. Hereinafter, FIG. 11A will be further described with reference to FIG. 11B and FIG. 11C.

FIG. 11B is a diagram illustrating an example of a process of forming an external structure of a substrate 911 according to various embodiments. FIG. 11C is a diagram illustrating an example of a process of forming an external structure of a substrate 911 according to various embodiments.

According to various embodiments, the packaging device 20 (e.g., the 3D printing device 610) may provide a material for generating a substrate in operation 1101, and perform 3D printing in operation 1103.

According to various embodiments, the packaging device 20 (e.g., the 3D printing device 610) may generate a substrate having at least one external structure in operation 1105. For example, referring to 1101S to 1103 S of FIG. 11B, the packaging device 20 (e.g., the 3D printing device 610) may form at least one of a base layer 1 100a, a conductive layer 1100b disposed on the base layer 1100a, an external protrusion structure 1100c of a specific thickness disposed on the conductive layer 1100b, or a protective layer 1100d disposed on the conductive layer 1100b based on 3DP. For example, the packaging device 20 (e.g., the 3D printing device 610) may form the external protrusion structure 1100c and the protective layer 1100d based on 3DP. However, the present disclosure is not limited to the example, and the packaging device 20 (e.g., the 3D printing device 610) may perform a process of forming both the base layer 1 100a, the conductive layer 1100b, the external protrusion structure 1100c, and the protective layer 1100d based on 3DP.

According to various embodiments, the material of the base layer 1100a may be a dielectric material such as ceramics.

According to various embodiments, the material of the conductive layer 110b may be a metal material such as copper.

According to various embodiments, the material of the outer protruding structure 1100c may be a hydrophobic material such as fluorine-based Teflon, and the material of the protective layer 1100d may be a hydrophilic material such as PMMA. However, the material of the outer protruding structure 1 100c and the material of the protective layer 1 100d are not limited to the described example, and the material of the outer protruding structure 1 100c and the material of the protective layer 1100d may be implemented by various materials that can be removed by a specific solvent. In this case, the outer protruding structure 1100c may be implemented to have a property different from that of the protective layer 1100d described later. For example, the material of the outer protruding structure 1100c may have hydrophobicity, and the material of the protective layer 1100d may have hydrophilicity, but each of the material of the outer protruding structure 1100c and the material of the protective layer 1100d may be implemented to have a property opposite to that of the described example. Accordingly, only one of the outer protruding structure 1100c and the protective layer 1100d may be removed by a specific solvent.

According to various embodiments, the material of the outer protruding structure 1100c may be a material having a first resolution (e.g., Teflon, and the like), and the material of the protective layer 1100d may be a material having a second resolution lower than the first resolution (e.g., PMMA, and the like). As shown in FIG. 11B, the outer protruding structure 1100c and the protective layer 1000d may be implemented in contact with each other, and by the outer protruding structure 1100c having a higher resolution, the roughness (or resolution) of the outline (outline) of the protective layer 1 100d contacted with the outer protruding structure 1100c may be guaranteed to be above a specific level (e.g., above the resolution level of the outer protruding structure 1100c).

According to various embodiments, as the process of forming the outer protruding structure 1100c of the Teflon material is performed, the resolution of the protective layer 1100d formed based on 3DP may be guaranteed to be above the specific level. For example, the protective layer 1010OD may be used as a Teflon material.

According to various embodiments, the packaging device 20 may perform an additional process in operation 1107. For example, referring to 1105S of FIG. 11B, 1107S and 1109S of FIG. 11C, the packaging device 20 may perform an additional process of providing a first solvent (e.g., a hydrophobic solvent) to remove the outer protruding structure 1100c, etching the exposed conductive layer 1100b as the protruding structure 1100c is removed, and providing a second solvent (e.g., a hydrophilic solvent) having a property different from the first solvent to remove the protective layer 1100d. As a result, a conductive layer having a specific outer structure (or pattern P) may be formed on the base layer 1 100a. The width W of the specific outer structure P may be implemented to have a resolution in um units corresponding to the resolution of the material of the 3DP substrate. Accordingly, as compared to a process of performing etching using conventional exposure processes, etching processes may be performed based on 3DP without equipment for exposure processes, and thus a convenience of the process may be improved and operational burden may be reduced.

According to various embodiments, the structure 1100 produced by the packaging device 20 may be used to form an electrical circuit. In this case, heat generated by the pattern p may be released by excellent performance.

### 3.1.2 Generating a substrate

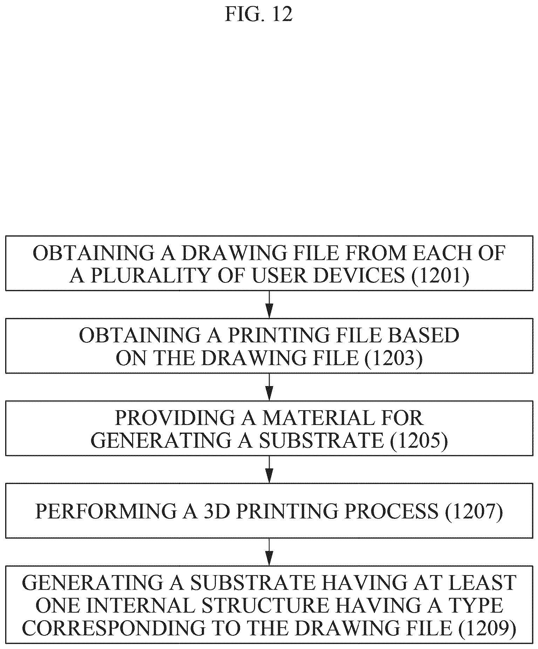

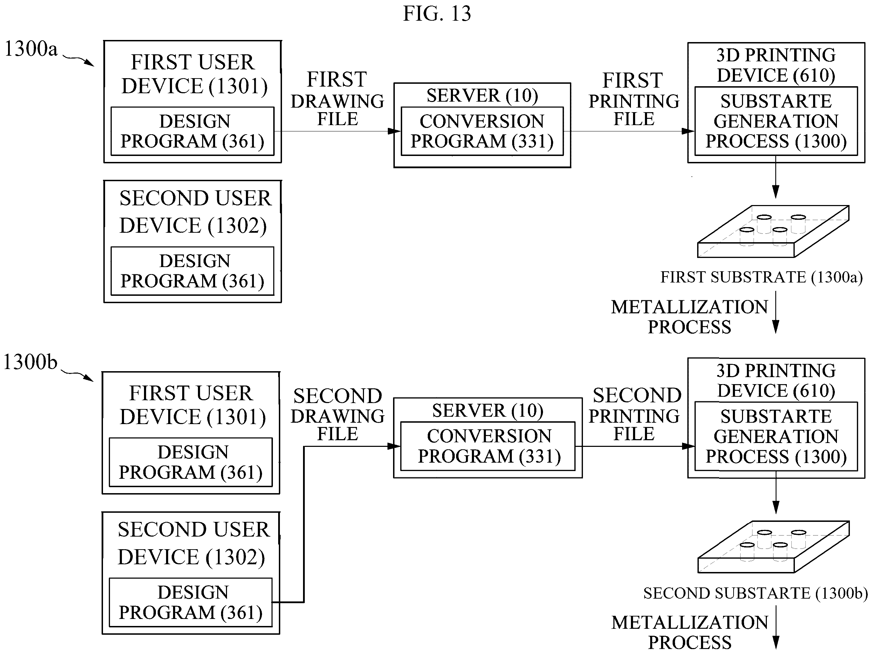

FIG. 12 is a flowchart illustrating an example of an operation for generating a substrate 911 based on a drawing file received from user devices according to various embodiments. Operations may be performed regardless of the order of operations shown and/or described, and more and/or fewer operations may be performed. Hereinafter, referring to FIG. 13, FIG. 12 will be further described.

FIG. 13 is a diagram for explaining an example of an operation of generating different substrates 911 according to a drawing file received from user devices according to various embodiments.

According to various embodiments, the customized 3D printing system 1 (e.g., the server 10) may obtain a drawing file from each of a plurality of user devices in operation 1201 and obtain a printing file based on the drawing file in operation 1203. For example, referring to FIG. 13, various consumers who want to use the customized 3D printing system 1 may operate different user devices (e.g., first user device 1301 and second user device 1302). Different user devices (e.g., the first user device 1301 and the second user device 1302) may be implemented to store the design program 361 and generate drawing files (e.g., the first drawing file and the second drawing file) based on the design program 361. The server 10 may receive drawing files (e.g., first drawing files and second drawing files) from each of the plurality of user devices (e.g., first user device 1301 and second user device 1302), and acquire different print files (e.g., first print files and second print files) based on the conversion program 331.

According to various embodiments, the customized 3D printing system 1 (e.g., the packaging apparatus 20) may provide a material for generating a substrate in operation 1205, perform 3D printing process in operation 1207, and generate a substrate having at least one internal structure (e.g., a penetration structure) of a type corresponding to the drawing file in operation 1209. Operations 1205 to 1290 of the customized 3D printing system 1 (e.g., the packaging device 20) may be performed like operations 1001 to 1005 of the packaging device 20 (e.g., the 3D printing device 610) described above, and thus redundant descriptions will be omitted. Referring to FIG. 13, the server 10 may transmit a control signal for controlling the packaging device 20 (e.g., the 3D printing device 610) to generate a substrate corresponding to the print file based on the print files (e.g., the first print file and the second print file). Alternatively, without limitation to the example, the server 10 may provide the print file to the packaging device 20 so that the packaging device 20 directly performs the 3D printing process based on the print file. The packaging device 20 (e.g., the 3D printing device 610) may generate different substrates (or dielectric layers) 1300a and 1300b based on print files (e.g., first print file and second print file) received from the server 10. The different substrates 1300a and 1300b may be implemented to include different penetration structures, as shown in FIG. 13.

### 3.1.3 Correction operation for the substrate generation

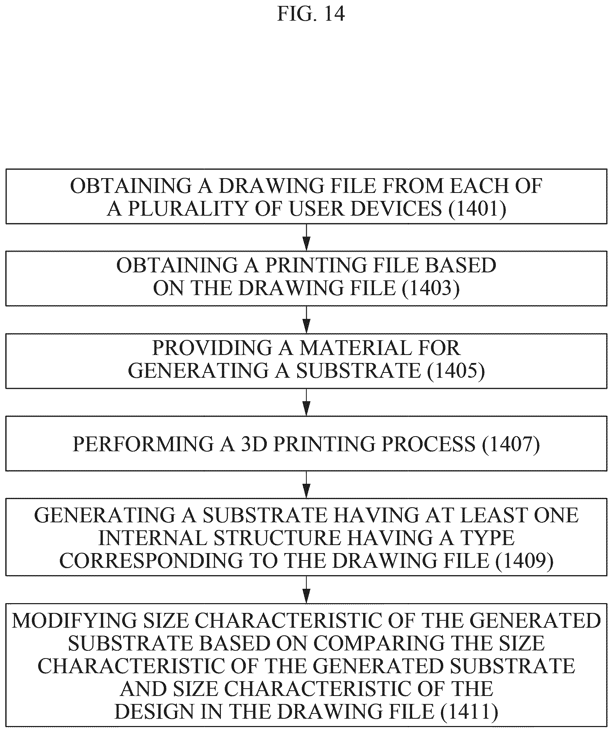

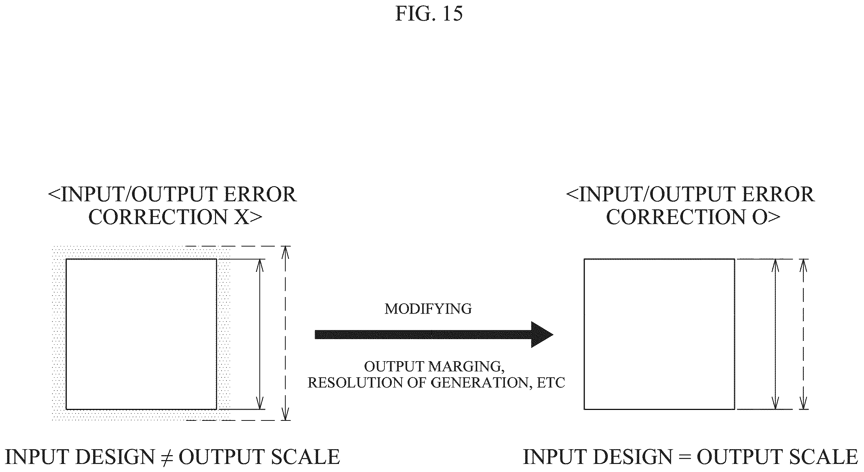

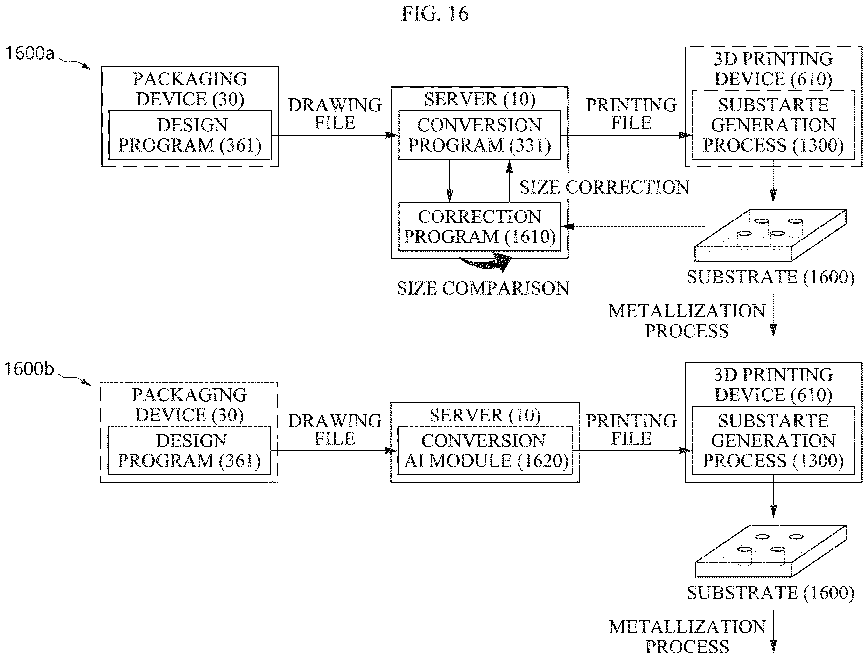

FIG. 14 is a flowchart illustrating an example of an operation of correcting the size of the substrate 911 as at least a part of the 3DP-based substrate formation operation according to various embodiments. Operations may be performed regardless of the order of operations shown and/or described, and more and/or fewer operations may be performed. Hereinafter, FIG. 13 will be further described with reference to FIGS. 15 and 16.

FIG. 15 is a diagram for describing an example of an operation of correcting a size according to various embodiments. FIG. 16 is a diagram for describing examples of an operation of correcting a size of the server 10 according to various embodiments.

According to various embodiments, the customized 3D printing system 1 (e.g., the server 10) may obtain a drawing file from each of a plurality of user devices in operation 1401, and may obtain a printing file based on the drawing file in operation 1403. Operations 1401 to 1403 of the customized 3D printing system 1 (e.g., the server 10) may be performed as in operations 1201 to 1203 of the aforementioned customized 3D printing system 1 (e.g., the server 10), and thus redundant descriptions will be omitted.

According to various embodiments, the customized 3D printing system 1 (e.g., the packaging device 20) may provide a material for generating a substrate in operation 1405, perform 3D printing in operation 1407, and generate a substrate having at least one internal structure (e.g., a penetration structure) of a kind corresponding to the drawing file in operation 1409. Operations 1405 to 1409 of the customized 3D printing system 1 (e.g., the packaging device 20) may be performed as in operations 1205 to 1009 of the aforementioned customized 3D printing system 1 (e.g., the packaging device 20) and thus redundant descriptions will be omitted.

According to various embodiments, the customized 3D printing system 1 (e.g., the packaging device 20) may modify the size characteristic of the substrate based on comparing the size characteristic of the generated substrate and the size characteristic of the design in the file in operation 1411. For example, the size characteristic means the size of the component constituting the substrate 911, and may mean, for example, the width and/or length of the body of the substrate 911, the diameter and/or width of the penetration structure (or hole) formed inside the substrate 911, or the size of other physical structure formed.

Referring to FIG. 15, the size characteristic of the input design (e.g., the design included in the printing file) and the size characteristic of the output scale (e.g., the substrate 911 produced by the packaging device 20) may be different. In order to remove and/or reduce the difference in the size characteristic, the server 10 may perform an operation of correcting (or modifying or changing) the size characteristic of the design included in the printing file.

In an embodiment, as illustrated in 1600a of FIG. 16, the server 10 may further include a correction program 1610, and may compare the size characteristic of the design included in the printing file and the size characteristic of the produced substrate 911 based on the correction program 1610, and may modify the size characteristic of the substrate 911 in the printing file based on the comparison result. For example, the server 10 may reduce the size characteristic of the substrate 911 in the printing file when the size characteristic of the substrate 911 is greater than the size characteristic of the substrate 911 in the printing file, and may increase the size characteristic of the substrate 911 in the printing file when the size characteristic of the substrate 911 is less than the size characteristic of the substrate 911 in the printing printing file. Accordingly, the server 10 may generate the substrate 911 having the size characteristic corresponding to the drawing a (i.e., suitable for the consumer's demand) based on the basis of the printing file when the size characteristic is changed.

In another embodiment, as illustrated in 1600b of FIG. 16, the server 10 may further include a conversion AI module 1620, and may convert the drawing file into a print file having an optimized size characteristic based on the conversion AI module 1620. For example, the conversion ai module 1620 may be an artificial intelligence model that is trained by training the drawing file and the finally corrected print file received from the user device as training data. The learning is based on a guidance learning method (e.g., a support vector machine (SVM)) by regression and classification, a non-guidance learning method such as clustering, and an enhanced learning method such as deep learning, and is a well-known technique, and thus detailed descriptions thereof will be omitted. For example, as described above, the server 10 may acquire the corrected print file based on the drawing file and the correction program 1610, perform learning by using the drawing file as input data, and using the corrected print file as output data, thereby generating the conversion ai module 1620 that is implemented to facilitate the print file when the drawing file is input. Since the print file output from the conversion ai module 1620 is a print file corrected in consideration of the correction error, the process may be efficiently performed without a cumbersome correction operation using the correction program 1610.

Meanwhile, the correction program 1610 and the conversion ai module 1620 are not limited to the described and/or illustrated examples, and may be implemented in the 3D printing device 610 rather than the server 10 to perform the above-described operation.

### 3.2 Metallization process

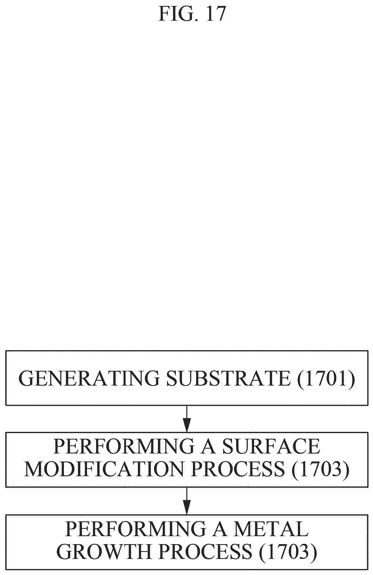

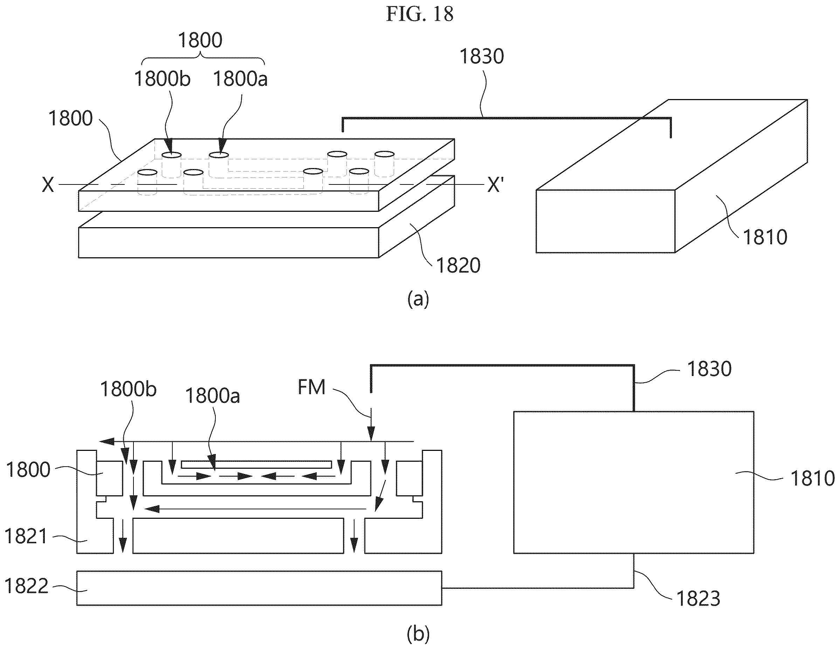

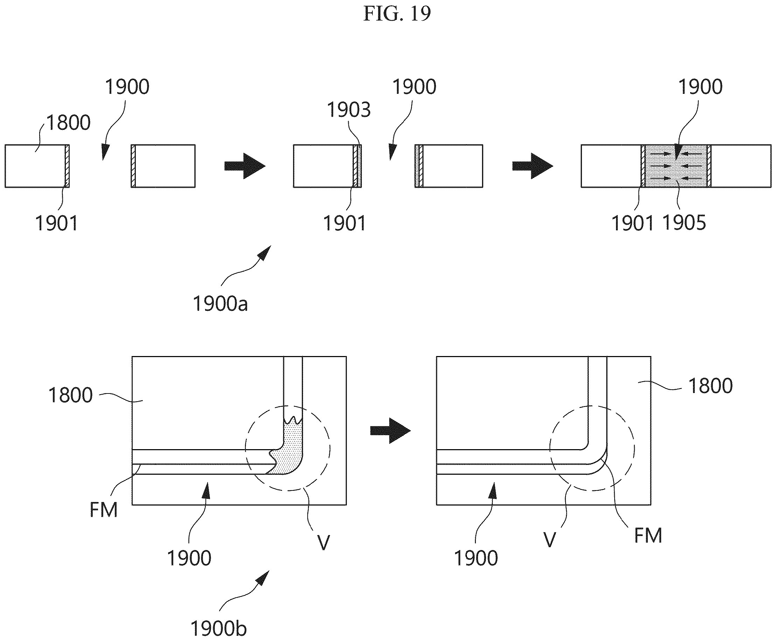

FIG. 17 is a flowchart illustrating an example of a metallization process according to various embodiments. Operations may be performed regardless of the order of the operations shown and/or described, and more operations may be performed and/or fewer operations may be performed. Hereinafter, FIG. 17 will be further described with reference to FIGS. 18 and 19.

FIG. 18 is a diagram illustrating an example of a metallization device 620 for a metallization process according to various embodiments. FIG. 19 is a diagram illustrating an example of an operation of removing internal defects formed in a through structure inside a substrate 911 during a metallization process according to various embodiments.

According to various embodiments, the customized 3D printing system 1 (e.g., the packaging device 20) may generate the substrate 1800 in operation 1701. Operation 1701 of the customized 3D printing system 1 (e.g., the packaging device 610) may be performed as described above in the "3. 3DP-based substrate formation process", and thus redundant descriptions thereof will be omitted. The metallization device 620 may receive (or receive) the substrate 1800 generated by the 3D printing device 610 through a trailer, and may continue to perform the metallization process based on the received substrate 1800. The fluid conductive material may include copper of a fluid, but is not limited to the described examples, and may be various materials having conductive properties.

According to various embodiments, as shown in 1800a of FIG. 18, the metallization device 620 may include a base 1820 on which a substrate 1800 having at least one penetration structure 1800 a and 1800 b formed therein is placed, a provision member 1830 (e.g., a tube) for providing a fluid conductive material (e.g., a fluid metal), a storage structure 1810 for storing a fluid conductive material (e.g., a fluid metal), and a pump (not shown) for transferring the fluid conductive material from the storage structure 1810 to the substrate 1800 through the provision member 1830. However, the metallization device 620 may be implemented to include more or fewer components, without limitation to the examples described and/or shown.

According to various embodiments, as shown in 1800b of FIG. 18, the base 1820 of the metallization device 620 may include a body 1821 on which the substrate 1800 is placed, and a recovery structure 1822 for recovering a fluid metal material. The body 1821 may be provided with a protrusion on which the substrate 1800 may be seated, and for example, as shown in 1800b of FIG. 18, the body 1821 may be provided with a protrusion on an inner surface of a side surface of the body 1821. In the state in which the substrate 1800 is seated, the body 1821 may be designed so that the height of the side surface of the body 1821 is higher than the position of the upper surface of the substrate 1800. Accordingly, the fluid conductive material FM by the provision member 1830 may be smoothly provided on the substrate 1800. In addition, a through hole may be formed on at least a portion of the body 1821 to remove and/or recover the remaining fluid conductive material FM after the metallization process is completed, and for example, as shown in 1800b of FIG. 18, the through hole may be formed on a lower surface of the body 1821. The recovery structure 1822 may be disposed at a position for recovering the remaining fluid conductive material FM after the process provided from the through hole, and the fluid conductive material FM may be provided to the storage structure 1810 again through the tube 1823. The recovery may be performed by the above-described pump (not shown).

According to various embodiments, the customized 3D printing system 1 (e.g., the metallization device 620) may perform a surface modification process in operation 1703. For example, referring to 1900a of FIG. 19, the metallization device 620 may perform hydrophilization 1901 on an inner surface of the penetration structure 1900 (e.g., a hole) formed inside the substrate 1800. For example, the metallization device 620 may perform hydrophilization based on at least one method of plasma treatment, atomic layer deposition, or image vapor deposition. Accordingly, an oxidation film MOx in atomic units may be formed on an inner surface of the penetration structure 1900. As the inner surface of the penetration structure 1900 is hydrophilized, metal growth may be smoothly performed later.

According to various embodiments, the customized 3D printing system 1 (e.g., the metallization device 620) may perform a metal growth process in operation 1705. For example, referring to 1900a of FIG. 19, the metallization device 620 may grown a metal 1905 on an inner surface of the penetration structure 1900 (e.g., a hole) formed inside the substrate 1800, and may form a fine interconnect (or metal line).

According to various embodiments, the metallization device 620 may perform metal seed layer 1903 formation and metal growth 1905 based on at least one of electroless plating or electrolytic plating. For example, the electroless plating may be based on capillary phenomena and/or fine fluid control. For example, the metallization device 620 may provide fluid conductive material FM on the substrate 1800 through the providing member 830 as at least a part of the operation of performing electroless plating using the capillary phenomenon, and control the fluid conductive material FM on the substrate 1800 to penetrate into the through structure 1900 in the µm unit of the interior of the substrate 1800 by capillary phenomenon. In addition, for example, the metallization device 620 may provide a fluid conductive material FM and control a flow rate in a state where the fine providing member 830 formed in units of µm is inserted into the penetration structure 1900 in µm units of the substrate 1800. For example, the electrolytic plating may provide a fluid conductive material FM on the surface of the through structure 1900 inside the substrate 1800 by disposing an anode and a cathode and applying power to at least one of the anode and the cathode. The metallization device 1820 is at least a part of an operation of performing electrolytic plating, and may perform an operation of applying a positive voltage, applying a reverse voltage, and not-applying voltage for a fine penetration structure having a high aspect ratio (e.g., having an aspect ratio of 10 or more). For example, the metallization device 1820 may perform metal growth by applying the positive voltage (or current) for a first period, may perform metal dissolution by applying the reverse voltage (or current) application for a second period, and may have a dormant period by not-applying the voltage for a third period, wherein the first period, the second period, and the third period are defined as one cycle. the metallization device 1820 may repeat the one cycle, and may control a time length of each of the first period, the second period, and the third period included in the one cycle for conducting a uniform plating process through concentration control of ion distribution. In this case, the first period of applying the positive voltage and the second period of applying the reverse voltage may be set different from each other. For example, the first period may be set to be longer than the second period, but it is not limited to the examples described and may be set to be opposite.

In an embodiment, the metallization device 620 may use electroless plating to form the metal seed layer 1903 and grow the metal 1905.

For example, the metallization device 620 may perform the formation of the metal seed layer 1903 and the growth of the metal 1905, all based on the capillary phenomenon. As described above, the metallization device 620 may perform the formation of the metal seed layer 1903 and the growth of the metal 1905 by adjusting the amount of the fluid conductive material FM provided on the substrate 1800 using the provision member 1830 and adjusting the amount of the fluid conductive material FM provided to the through structure 1900 by the capillary phenomenon. For example, the metallization device 620 may provide a first amount of fluid conductive material FM to form the metal seed layer 1903 and provide a second amount of fluid conductive material FM larger than the first amount after the metal seed layer 1903 is formed to grow the metal 1905, but the amount of fluid conductive material FM may be set to the contrary without being limited to the example. At this time, the metallization device 620 may vary the process conditions (e.g., temperature) of the first period in which the metal seed layer 1903 is formed and the second period in which the metal 1905 is grown. For example, the temperature of the second period may allow the metal to grow faster than the temperature of the first period, but is not limited to the examples described, and the temperature may be set oppositely.

In addition, for example, the metallization device 620 may form the metal seed layer 1903 based on the capillary phenomenon, and perform the growth of the metal 1905 based on the fine fluid adjustment. The metallization device 620 may perform metal growth by providing a fluid conductive material FM in a state where the fine providing member 830 formed in µm units is inserted into the penetration structure 1900 in µm units of the substrate 1800 after the metal seed layer 1903 is formed based on the capillary phenomenon. For example, the metallization device 620 may provide fluid conductive material FM at a first flow rate to form the metal seed layer 1903 and provide fluid conductive material FM at a second flow rate slower than the first flow rate after the metal seed layer 1903 is formed to grow the metal 1905, but the flow rate of the fluid conductive material FM may be set to be opposite.

In addition, for example, the metallization device 620 may perform the formation of the metal seed layer 1903 and the growth of the metal 1905 based on the adjustment of the fine fluid. The metallization device 620 may perform the formation of the metal seed layer 1903 and the growth of the metal 1905 based on adjusting the flow rate of the fluid conductive material FM in a state where the fine providing member 830 formed in µm units is inserted into the penetration structure 1900 in µm units of the substrate 1800.

In another embodiment, the metallization device 620 may form the metal seed layer 1903 based on electroless plating, and grow the metal 1905 based on electrolytic plating.

In another embodiment, the metallization device 620 may form the metal seed layer 1903 based on electrolytic plating, and grow the metal 1905 based on electroless plating.

In another embodiment, the metallization device 620 may form the metal seed layer 1903 based on electrolytic plating and grow the metal 1905.

According to various embodiments, the metallization device 1820 is at least a part of the metallization process, and as shown in 1900b of FIG. 19, may perform an operation for removing and/or reducing internal defects V formed in the through structure 1900. The internal defect is a void, and may mean an empty space in which the fluid conductive material FM is not filled, but is not limited to the examples described, and may mean foreign substances other than the fluid conductive material FM. The detection of the internal defect V may be detected through a connectivity test using the test analysis device 650 described above, but is not limited to the examples described.

For example, the metallization device 1820 may remove and/or reduce the internal defect V by controlling the amount or flow rate of the fluid conductive material FM when electroless plating is used as at least a part of the operation of removing the internal defect V. For example, the metallization device 1820 may remove and/or reduce the internal defect V by increasing the amount of fluid conductive material FM or dynamically changing the flow rate when the internal defect V occurs, such that the fluid conductive material FM is provided as the internal defect V.

As another example, the metallization device 1820 further includes a vibration device (not shown) (or an ultrasonic device) in the base 1820 on which the substrate 1800 is disposed, and as at least a part of the operation of removing internal defects V, vibration is provided to the substrate 1800 by using the vibration device (or ultrasonic device) so that the fluid conductive material FM is provided as the internal defect V, thereby removing and/or reducing the internal defect V.

### 3.3 Bump formation and bonding process

According to various embodiments, the packaging device 20 may perform a process of forming bumps on the substrate 910 including the interconnect as described above and physically and/or electrically connecting the bumps to other electronic components (e.g., chips, packaging substrates), and detailed descriptions thereof will be omitted.

### 3.4 Other process

According to various embodiments, the packaging device 20 may generate a packaging structure (e.g., a substrate having a bump) in a form physically and/or electrically connected to a conventional interconnect structure. For example, the packaging device 20 (e.g., the bonding device 640) may bonding the packaging structure (e.g., a substrate having a bump) to the conventional interconnect structure (e.g., the redistribution layer (RDL), the silicon through electrode (TSV)). In addition, the packaging device 20 may further include a facility (not shown) for generating the conventional interconnect structure, and may form the conventional interconnect structure on the packaging structure (e.g., the substrate having a bump).

### 4. Packaging structures and application products

Hereinafter, examples of the packaging structure generated by the aforementioned customized 3DP system 1 and the application product to which the packaging structure is applied will be described according to various embodiments.

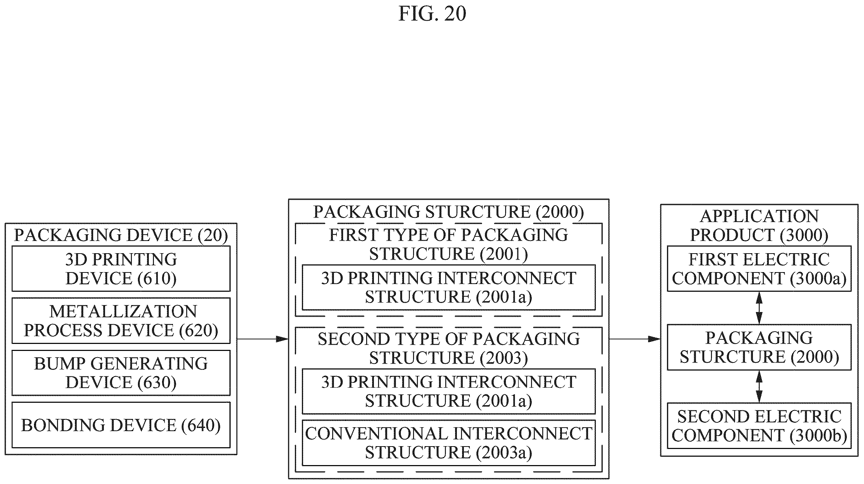

FIG. 20 is a diagram for describing examples of the packaging structure and the application products according to various embodiments.

According to various embodiments, referring to FIG. 20, the packaging structure 2000 may be formed by the packaging device 20 (e.g., the 3D printing device 610, the metallization device 620, the bump generation device 630, and the bonding device 640), and the packaging structure 2000 may be provided and used in another application product 3000.

According to various embodiments, the packaging structure 2000 may be implemented by the first type of packaging structure 2001 including only the 3D printing interconnect structure 2001a (e.g., a structure formed based on the processes of the packaging device 20 described above), and the second type of packaging structure 2003 where the 3D printing interconnect structure 2001a and the conventional high-resolution structure 2003a (e.g., the redistribution layer (RDL) and the silicon through electrode (TSV)) are physically and/or electrically connected, and examples of each structure will be described in detail.

In various embodiments, the application product 3000 may include the packaging structure 2000 and a product including a plurality of electronic components (e.g., the first electronic component 3000a and the second electronic component 3000b) connected to the packaging structure 2000, and may include various types of devices as described above with reference to FIG. 2.

### 4.1 Packaging structure

### 4.1.1 First type of structure

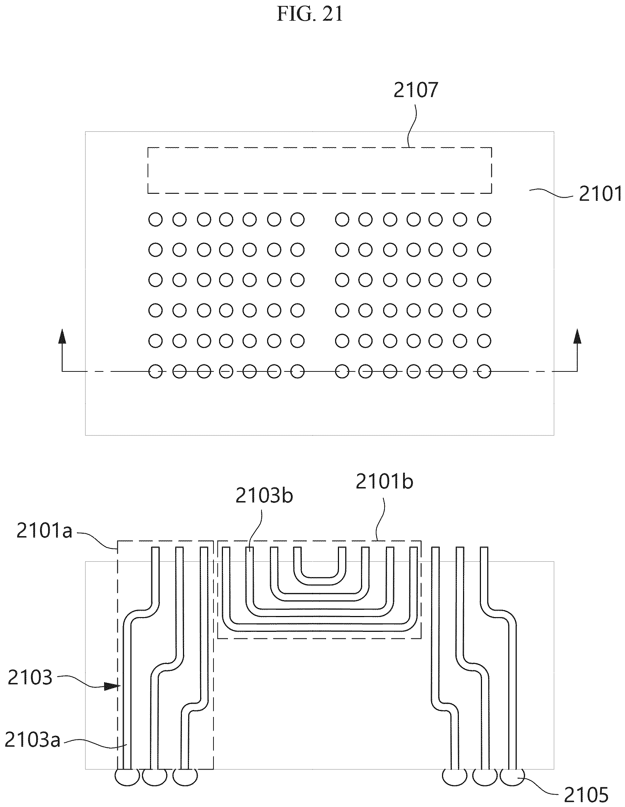

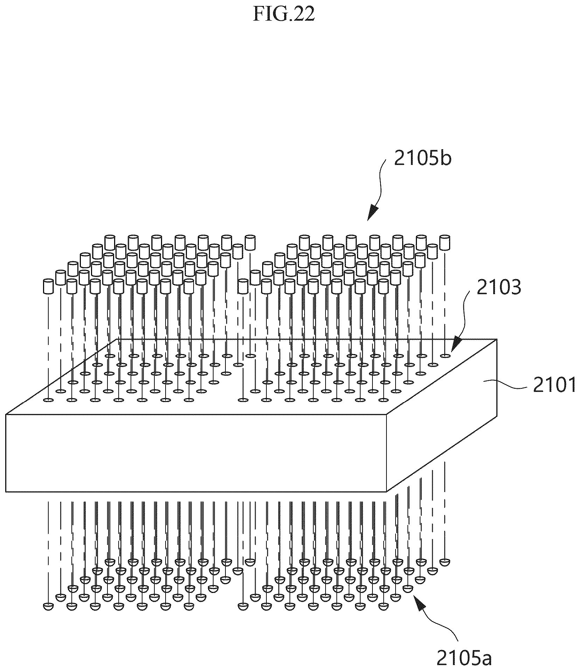

FIG. 21 is a diagram for describing an example of the first type of packaging structure according to various embodiments. FIG. 22 is an exploded perspective view of an example of the first type of packaging structure according to various embodiments.

According to various embodiments, referring to FIG. 21, the first type of packaging structure 2001 may include the substrate 2101 (or a dielectric layer), at least one interconnect 2103 (or a metal line), at least one bump 2015 connected to the at least one interconnect 2103, and other internal structures 2107. In this case, referring to FIG. 22, the bump 2015 includes interconnects 2105a, 2105b connected to the upper and lower parts of the interconnect, respectively, and may be different from the same as illustrated. Meanwhile, the first type of packaging structure 2001 may be implemented to include more components and/or less components, without being limited to the illustrated and/or described examples.

According to various embodiments, the substrate 2101 (or dielectric layer) may be implemented by the 3D printing device 610, as described above. The substrate 2101 (or dielectric layer) may be implemented as a single layer, different from the conventional high-resolution structure 2003a implemented as a plurality of layers. For example, the layer is a component that physically separates the dielectric layer, and for example, may be separated into upper and lower parts of the dielectric layer based on the layer as a layer of conductive material different from the material of the dielectric layer.

According to various embodiments, the substrate 2101 (or dielectric layer) may be implemented to have various shapes by the 3D printing device 610. For example, the substrate 2101 may be implemented in a shape corresponding to the shape of the inner space in which the packaging structure 2001 is to be disposed in the application product 3000. The shape may include various shapes not only in the form of a rectangular parallelepiped, but also polygonal pillars such as triangular pillars, circular pillars, and spherical shapes, etc., which are not limited to the illustrated examples.

According to various embodiments, the at least one interconnect 2103 may be formed in various directions. For example, the at least one interconnect 2103 may include a first portion exposed through the upper surface of the substrate 2101, a second portion exposed through the lower surface, and a line connecting between the first portion and the second portion. The line may be implemented to cross the inside of the substrate 2101 of the above-described single layer structure in the transverse direction and/or longitudinal direction, and have a specific curvature (or angle, or slope) in some sections. When the plurality of interconnects are implemented, as shown in FIG. 21, at least one of the portions where the curvature is formed of each of at least two interconnects among the plurality of interconnects, the number of portions of each of the at least two interconnects, or the numerical value of the curvature of each of the at least two interconnects may be different. As the at least one interconnect 2103 implemented in the substrate 2101 may be implemented in various shapes, when applied to the above-described various types of application products 3000, the interconnect 2101 is optimally formed in a form suitable for the application products 3000, and thus efficient electrical connectivity between electronic components included in the application products 3000 may be provided.

According to various embodiments, the at least one interconnect 2103 may include a first type of interconnect 2103a exposed to the outside through different surfaces and a second type of interconnect 2103b exposed to the outside through the same surface. The first type of interconnect 2103a is a type of interconnect implemented to electrically connect electronic components (e.g., chips) disposed on the upper surface and electronic components (e.g., packaging substrates) disposed on the lower surface, and may be a type of interconnect implemented to electrically connect electronic components (e.g., packaging substrates) disposed on the lower surface. The first type of interconnect 2103a may be implemented to provide a function of conventional silicon through electrodes (TSVs). The second type of interconnect 2103b may be a type of interconnect implemented to electrically connect electronic components (e.g., chips) disposed on the upper surface. The second type of interconnect 2103b may be implemented to provide a function like conventional redistribution layer (RDL).

Accordingly, the first type of interconnect 2103a included in the first portion 2101a of the substrate 2101 is implemented to perform the functions of the conventional silicon through electrode (TSV), and the second type of interconnect 2103b included in the second portion 2101b is implemented to perform the functions of the redistribution layer (RDL), so that the first type of packaging structure 2001 may provide efficiency to perform all functions of the conventional plurality of interconnect structures (TSV, RDL).

Meanwhile, the interconnect 2103 may be implemented in various ways as appropriate to the demands of the consumer as described and/or illustrated, and thus the packaging structure 2101 may include only the first type of interconnect 2103a or include only the second type of interconnect 2103b.

According to various embodiments, the other internal structure (configuration) 2107 may be formed at a position different from the above-described position at which the interconnect 2103 is formed. For example, the other internal structure (configuration) 2107 may include various shapes of empty space inside the substrate 2101. The empty space may be formed at a position different from the position at which the interconnect 2103 is formed, to improve the heat dissipation performance generated from the substrate 2101 and/or to reduce the physical stress applied to the substrate 2101. For example, the other internal structure 2107 may include a water passage structure. Through the water passage structure, a fluid for releasing waste heat of the substrate 2101 may be provided. For example, the other internal structure (configuration) 2107 may include a structure or a configuration for providing the functions of various components that may be implemented around the conventional semiconductor package, in addition to the above-described structures. Accordingly, as the configuration and/or the structure for implementing the various functions of the conventional is directly formed in the substrate 2101, the size of the packaging structure may be reduced, and more efficient electronic products may be implemented.

### 4.1.1.1 Various examples of the first type of packaging structure

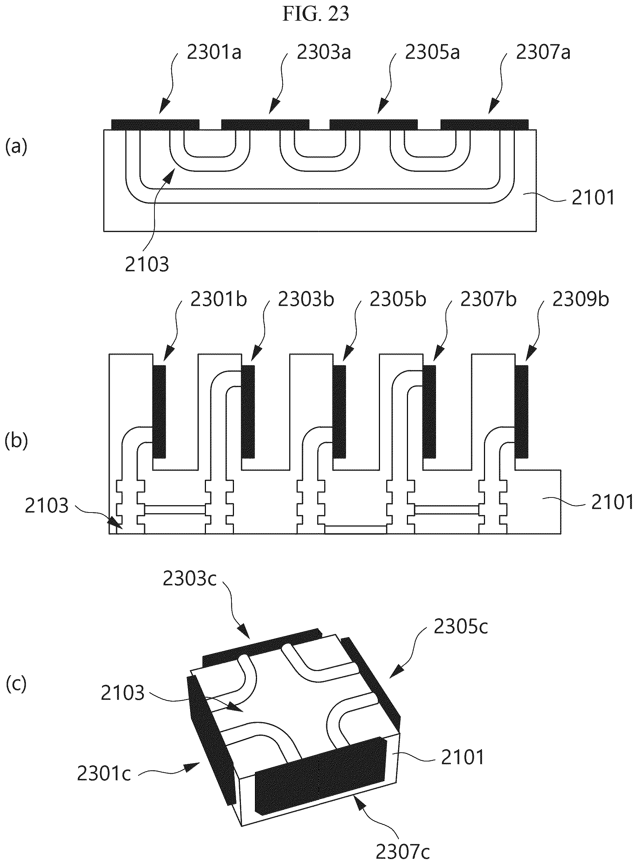

FIG. 23 is a diagram for describing various examples of the first type of packaging structure according to various embodiments.

Referring to FIG. 23, the first type of packaging structure 2001 according to various embodiments may be provided in various shapes.

For example, as illustrated in 2300a of FIG. 23, the substrate 2101 may include at least one interconnect 2103 for connecting the plurality of chips 2301a, 2303a, 2305a, and 2307a. The at least one interconnect 2103 may include a type of interconnect for connecting the chips adjacent to each other (e.g., the first chip 2301a and the second chip 2303a, the second chip 2303a and the third chip 2305a, the third chip 2305a and the fourth chip 2307a), and a type of interconnect for connecting the chips spaced apart from each other (e.g., the first chip 2301a and the fourth chip 2307a).

For example, as illustrated in 2300b of FIG. 23, the substrate 2101 may be implemented to include a plurality of protruding portions in which each of the plurality of chips 2301b, 2303b, 2305b, 2307b, and 2309b is disposed, and to include at least one interconnect 2103 in which a first portion is exposed through a side surface of each of the plurality of protruding portions and a second portion is exposed through a bottom surface.

For example, as illustrated in 2300b of FIG. 23, the substrate 2101 may be implemented to include at least one interconnect 2103 for electrically connecting a plurality of chips 2301c, 2303c, 2305c, and 2307c disposed on a plurality of sides.

### 4.1.2 Second type of structure

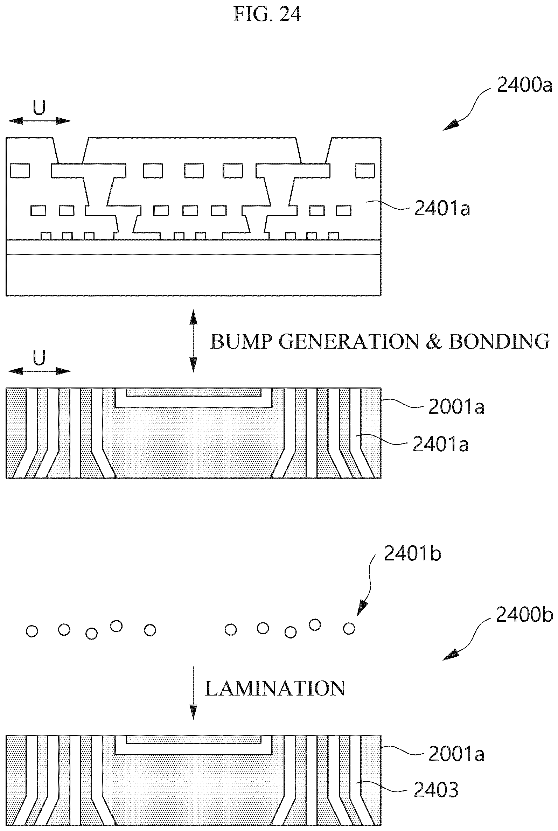

FIG. 24 is a diagram for describing various examples of the second type packaging structure 2003 according to various embodiments.

According to various embodiments, the second type packaging structure 2003 may be implemented in a form of physically (or electrically) connecting the first type packaging structure 2001a and the conventional interconnect structure 2401a (e.g., the redistribution layer (RDL)) as illustrated in 2400a of FIG. 24, and may be implemented based on performing a process (e.g., a deposition process) of forming the conventional interconnect structure 2401b (e.g., the redistribution layer (RDL)) on the first type packaging structure 2001a as illustrated in 2400b of FIG. 24.

According to various embodiments, at least one interconnect 2103 of the first type packaging structure 2001a and at least one interconnect of the second type packaging structure 2401a, 2401b may be electrically connected to each other.

According to various embodiments, the first density (e.g., the mass of the interconnect per unit volume and/or the number of interconnects) of the interconnect included in the first type packaging structure 2001a and the second density of the interconnect included in the conventional interconnect structure 2401a, 2401b may be different from each other. For example, the first density of the interconnect of the first type packaging structure 2001a may be implemented to be smaller than the second density of the interconnect of the conventional interconnect structure 2401a, 2401b. That is, the resolution of the electrical connection may be improved by additionally disposing the conventional interconnect structure 2401a, 2401b having a high density of the interconnect.

### 4.2 Application product

According to various embodiments, the application product (or the electronic device) may be implemented to include various types of electronic components (or semiconductor devices). In this case, various types of electronic components (or semiconductor devices or electronic devices) may be electrically connected (or operatively connected) to each other, and thus may be set to provide at least one function. The packaging structure 2000 (e.g., the first type packaging structure 2001 and the second type packaging structure 2003) described above may be used to electrically (or operatively) connect electronic components (or semiconductor devices), which are variously mounted for each application product (or electronic device).

### 4.2.1 Chip packaging

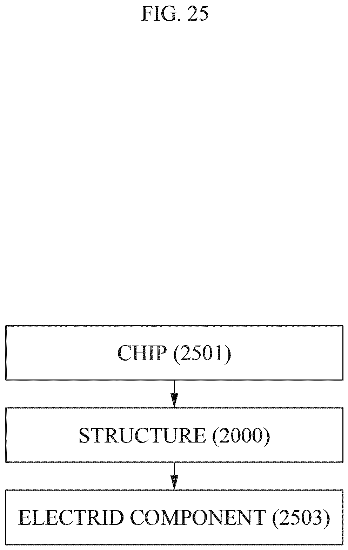

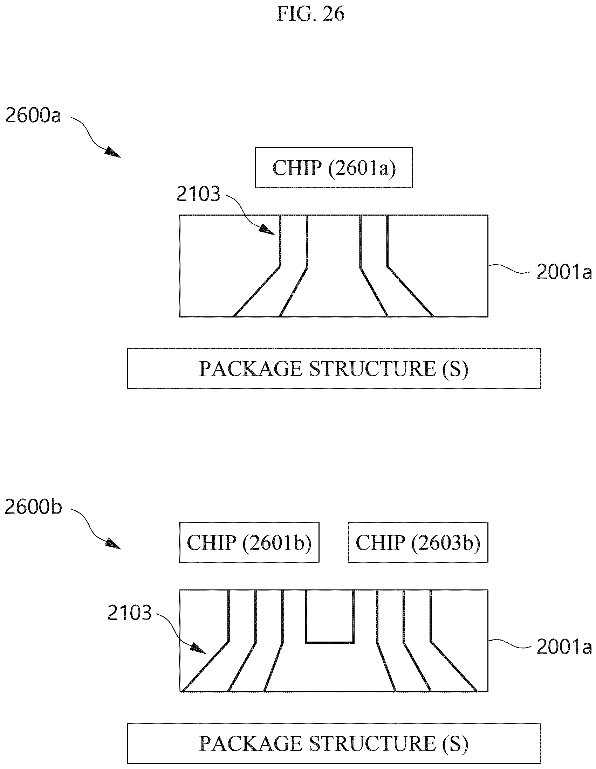

FIG. 25 is a diagram for describing an example of a packaging structure used in an application product according to various embodiments. Hereinafter, FIG. 25 will be further described with reference to FIGS. 26 to 27.

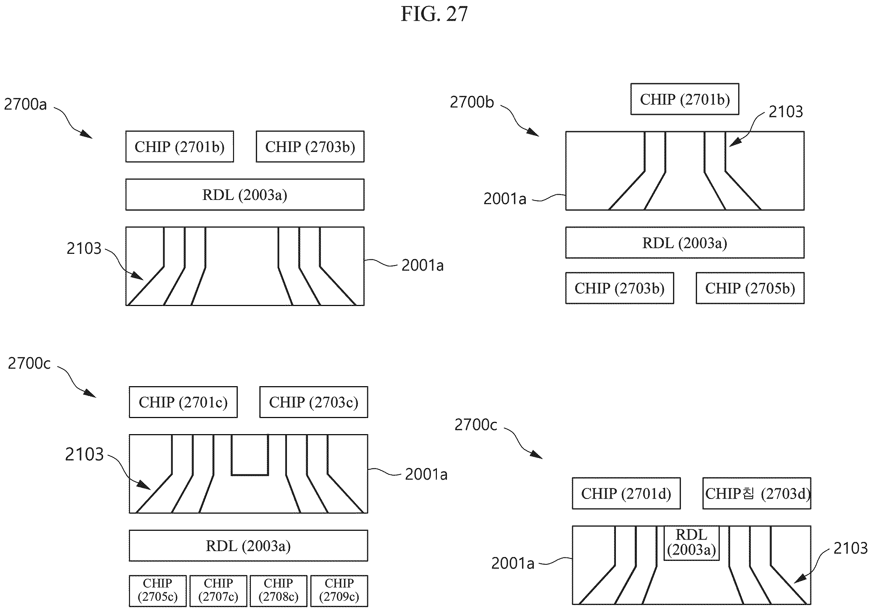

FIG. 26 is a diagram for describing an example of the first type packaging structure 2001 used in a chip package according to various embodiments. FIG. 27 is a diagram for describing an example of the second type packaging structure 2003 according to various embodiments.

According to various embodiments, the packaging structure 2000 (e.g., the first type packaging structure 2001 and the second type packaging structure 2003) may be used for a chip package for at least one chip included in various types of application products (or electronic devices). For example, referring to FIG. 25, the packaging structure 2000 may be used to electrically (or operatively) connect at least one chip 2501 and electronic components 2503. The chip 2501 may be understood as a broad concept that includes individual electronic devices (e.g., semiconductor devices such as diodes, transistors, MOSFETs, and resistors) as well as electronic circuits (e.g., integrated circuits such as memory chips, CPUs, APs, GPUs, and NPUs) that are electrically (or operatively) connected to two or more semiconductor devices that each performs a function.

According to various embodiments, the package for the at least one chip may include a package such as a system on chip (SOC) type that generates semiconductor devices as a single chip, a system in package type that generates heterogeneous chips as a unit structure, a package such as a chip-let type, a wafer-level package (WLP) such as a Fan-out WLP type, a Fan-out PLP type, and a Fan-in WLP type, and a package for a mobile processor such as 3D Fan-out, but is not limited to the examples described, and may include more types of packages.

### 4.2.1.1 Single chip package

According to various embodiments, referring to 2600a of FIG. 26, the first type of packaging structure 2001 may be implemented to electrically connect the chip 2601a and the substrate S. The first portion of the at least one interconnect 2103 exposed from the upper surface of the substrate 2001a may be electrically connected to the chip 2601a, and the second portion of the at least one interconnect 2103 exposed from the lower surface of the substrate 2001a may be electrically connected to the substrate S. Accordingly, the electrical signal generated from the chip 2601a may be provided to the substrate S, and the electrical signal may be provided as another component through the substrate S.

According to various embodiments, the distance between the at least one interconnect 2103 may be different for each portion of the substrate 2001a. For example, as shown in 2600a of FIG. 26, the distance between the interconnect 2103 in the portion close to the chip 2601a may be smaller than the distance between the interconnect 2103 in the portion close to the substrate S. In other words, the density of the interconnect 2103 in the portion close to the chip 2601a may be implemented to be smaller than the density of the interconnect 2103 in the portion close to the substrate S.

According to various embodiments, the first type of packaging structure 2001 used for the single chip package may be used for the purpose of silicon through electrode tsv.

### 4.2.1.2 Multichip package

According to various embodiments, referring to 2600b of FIG. 26, the first type of packaging structure 2001 may be implemented to electrically connect the plurality of chips 2601b and 2603b, and the plurality of chips 2601b and 2603b may be electrically connected to the substrate S. For example, as shown in 2600b of FIG. 26, the at least one interconnect of the substrate 2001a may be implemented to include the first type of interconnect 2103a and the second type of interconnect 2103b described above. Accordingly, the plurality of chips 2601b and 2603b may be connected to the substrate S through the first type of interconnect 2103a, and the plurality of chips 2601b and 2603b may be electrically connected to the second type of interconnect 2103b. The first type of interconnect 2103a may be implemented different distance for each area of the substrate 2001a, as the above.

### 4.2.1.3 Hybrid package

According to various embodiments, as shown in FIG. 27, the second type of packaging structure 2003 may be used for a chip package.

In an embodiment, as shown in 2700a of FIG. 27, the conventional high-resolution interconnect structure 2003a (e.g., the redistribution layer (RDL)) may be used for input of a higher density (or resolution) of electrical signals to the first type of structure 2001a including the first type of interconnect 2103a. The second type of packaging structure 2003 may include a first type of packaging structure 2001a and a conventional high-resolution interconnect structure 2003a (e.g., a redistribution layer (RDL)) disposed on the first type of packaging structure 2001a. Each of the plurality of chips 2701a, 2703a may be electrically connected to a conventional high-resolution interconnect structure 2003a (e.g., a redistribution layer (RDL)), the interconnect of the conventional high-resolution interconnect structure 2003a (e.g., a redistribution layer (RDL)) may be electrically connected to the interconnect 2103 of the substrate 2001a, and the interconnect 2103 of the substrate 2001a may be electrically connected to a packaging substrate (not shown).

In another embodiment, as illustrated in 2700b of FIG. 27, the conventional high-resolution interconnect structure 2003a (e.g., the redistribution layer (RDL)) may be used for the purpose of outputting a higher density (or resolution) of electrical signals to the first type of structure 2001a including the first type of interconnect 2103a. The second type of packaging structure 2003 may include a first type of packaging structure 2001a and a conventional high-resolution interconnect structure 2003a (e.g., a redistribution layer (RDL)) disposed under the first type of packaging structure 2001a. The first chip 2701b is electrically connected to the interconnect 2103 of the substrate 2001a, and the conventional high-resolution interconnect structure 2003a (e.g., the redistribution layer (RDL)) is electrically connected to the interconnect 2103 exposed through the lower surface of the substrate 2001a, and the conventional high-resolution interconnect structure 2003a may be electrically connected to other electronic components (e.g., the plurality of chips 2703b and 2705b).

In another embodiment, as shown in 2700c of FIG. 27, a first type of packaging structure 2001 including a first type of interconnect 2103a and a second type of interconnect 2103b and a second type of packaging structure 2003 including a conventional high-resolution interconnect structure 2003a (e.g., a redistribution layer (RDL)) may be provided. Since the electrical connection relationship may be formed as described above in 2700a and 2700b FIG. 27, redundant descriptions are omitted.

In another embodiment, as illustrated in 2700d of FIG. 27, the conventional interconnect structure 2003a may be implemented in a form included in the first type of packaging structure 2001. For example, the conventional high-resolution interconnect structure 2003a may be implemented in a form inserted into the upper groove of the substrate 2001a. That is, the conventional high-resolution interconnect structure 2003a may be implemented on the substrate 2001a to perform the functions of the second type of interconnect 2103b described above. Without being limited to the described and/or illustrated examples, the substrate 2001a may be implemented to include a second kind of interconnect 2103b, but to include a silicon through electrode (TSV), which is implemented to perform the function of the first kind of interconnect 2103a on the side surface.

### 4.2.2 An antenna in package (AIP)

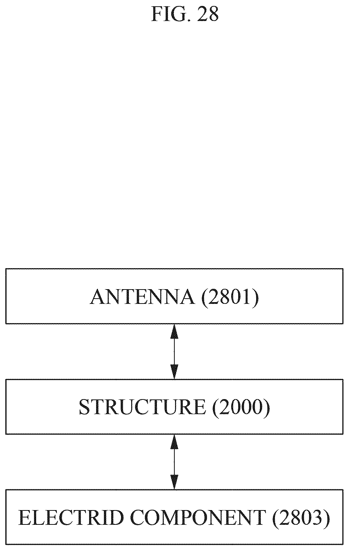

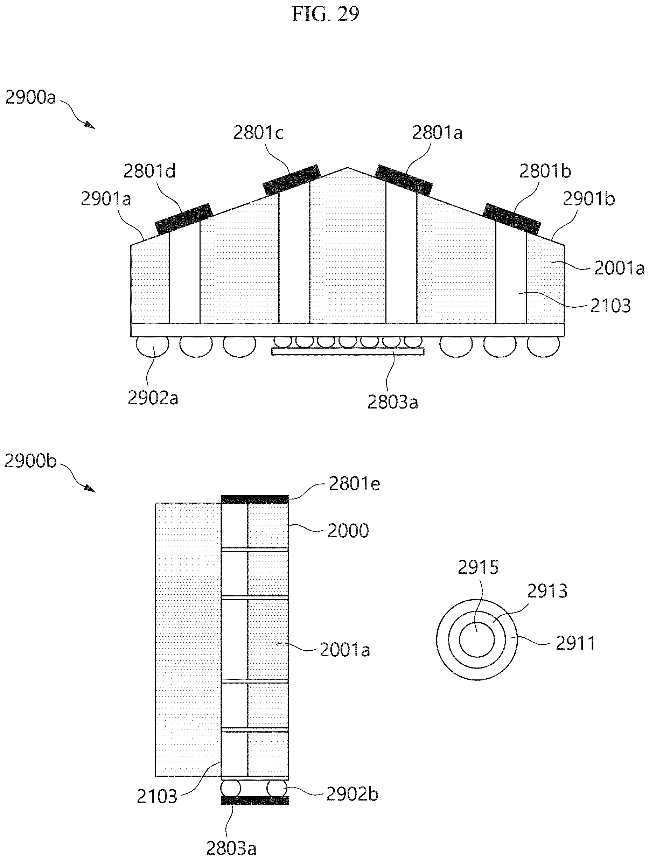

FIG. 28 is a diagram for explaining an example of a packaging structure used in an antenna in package according to various embodiments. Hereinafter, referring to FIG. 29, FIG. 28 will be further described.

FIG. 29 is a diagram for describing an example of a packaging structure used in an antenna in package according to various embodiments.

According to various embodiments, referring to FIG. 28, the packaging structure 2000 may be provided to electrically connect the antenna 2801 (or antenna chip) to another electronic component 2803 (e.g., a communication processor, a packaging substrate).

In an embodiment, the packaging structure 2000 may be used for various forms (e.g., curved and free antenna packaging). For example, referring to 2900a of FIG. 29, the substrate 2001 a includes a plurality of surfaces 2901a and 2901b implemented to face different directions (or different angles, or different slopes), and may be implemented to have a shape corresponding to an empty space in an application product (e.g., a mobile phone). The antenna chips 2801 a, 2801 b, 2801 c, and 2801 d may be disposed on each of the plurality of surfaces 2901 a and 2901 b. The first group of antenna chips 2801 c and 2801 d may be disposed on the first surface 2901 a, and the second group of antenna chips 2801 a and 2801 b may be disposed on the second surface 2901 b. The substrate 2001 a includes a plurality of interconnects 2103 electrically connected to each of the antenna chips 2801 a, 2801 b, 2801 c, and 2801 d, and the first group of interconnects may be electrically connected to the first group of antenna chips 2801 c and 2801 d through a region corresponding to the first surface 2901 a, and the second group of interconnects may be electrically connected to the second group of antenna chips 2801 a and 2801 b through a region corresponding to the second surface 2901 b. A plurality of bumps 2902 a may be formed under the substrate 2001 a, electrically connected to the plurality of interconnects 2103, and electrically connected to the other electronic component 2803 a. Accordingly, as they are electrically connected to the other electronic component 2803, the first group of antenna chips 2801 c and 2801 d and the second group of antenna chips 2801 a and 2801 b may broadcast wireless signals in different directions.

Meanwhile, although not illustrated, the substrate 2001 a may be implemented in various shapes such as a L-shape, and as described above, the antenna chips 2801 a, 2801 b, 2801 c, and 2801 d may be disposed on a surface formed to face different directions, and may be used in an antenna in package.

In another embodiment, the packaging structure 2000 may be used for a coaxial antenna waveguide package. For example, referring to 2900b of FIG. 29, the substrate 2001 a may be implemented to include a coaxial interconnect 2103, and the coaxial interconnect 2103 may be electrically connected to the antenna chip 2801 e and another electronic component 2803 via bumper 2902 b. In this case, the coaxial interconnect 2103 may be implemented to be a concentric circle structure including a ground 2911, a dielectric 2913, and a metal 2915, and may be implemented to be reflection and radiation in a receive wireless signal transmission reception process. In the conventional coaxial antenna waveguide package, as a plurality of layers are formed inside the substrate, a is formed by reflection of signals between the layers, and the coaxial interconnect 2103 is efficiently implemented, the above problems may be solved by the above problems.

Meanwhile, at least a part of the above-described process may further include a process of forming the ground 2911 and the dielectric 2913 so that the interconnect 2103 includes not only the metal but also the ground 2911 and the dielectric 2913. For example, during the 3DP-based substrate forming process 801, a process of forming the ground 2911 and the dielectric 2913 inside the through structure may be additionally performed. In addition, for example, during the metallization process 803, a process of forming the ground 2911 and the dielectric 2913 inside the through structure may be additionally performed.

### 4.2.3 Other application products

According to various embodiments, the packaging structure 2000 may be used in various ways to optimize the electrical connection between electronic components included in the application product based on the shape of the substrate and the structure of the interconnect, which are suitable for consumer demands (or various kinds of application products), as described above.

For example, the packaging structure 2000 may be used for a socket. For example, the socket may mean a test socket for testing a chip (e.g., memory, ASIC, etc.). The test socket may be a test socket that may grasp the performance of the chip through a space and a substrate output in which a through hole is formed to mount the chip using printing. As a result, the printing process may be possible without limitation on the shape and the number of chips.

## Claims

1. A semiconductor packaging module, comprising:
a single first semiconductor chip; and
a substrate including a first surface facing a lower surface of the first semiconductor chip, a second surface facing the first surface, and at least one first interconnect structure inside between the first surface and the second surface,
wherein the at least one first interconnect structure comprises a first portion exposed through the first surface, a second portion exposed through the second surface, and a line connecting between the first portion and the second portion,
wherein the first portion is electrically connected to the first semiconductor chip, and the second portion is electrically connectable to another electronic component, and
wherein the line is transverse to the body of the single layer structure, and is formed with a specific slope in at least some sections.

2. The semiconductor packaging module of claim 1, further comprising a second semiconductor chip,
wherein the substrate further comprises:
at least one second interconnect structure,
wherein the at least one second interconnect structure further comprises a third portion exposed through the first surface, a fourth portion exposed through the first surface, and a second line connecting the third portion and the fourth portion, and
wherein the third portion is connected to a first semiconductor chip, and the fourth portion is connected to a second semiconductor chip.

3. The semiconductor packaging module of claim 1, further comprising:
a second semiconductor chip; and
a structure comprising at least one second interconnect structure,
wherein a portion of the at least one second interconnect structure is electrically connected to the first semiconductor chip and the second semiconductor, and
wherein a remaining portion of the at least one second interconnect structure is electrically connected to at least one first interconnect pillar of the substrate.

4. The semiconductor packaging module of claim 3, wherein a first density of the at least one first interconnect structure is lower than a second density of the at least one second interconnect structure.

5. The semiconductor packaging module of claim 1, wherein the substrate comprises:
a body of a single layer structure; and
the at least one first interconnect structure formed inside the body,
wherein the at least one first interconnect structure comprises a first end portion exposed through a first surface of the substrate, a second end portion exposed through a second surface of the substrate, and a line connecting the first end portion and the second end portion, and
wherein the line is transverse in a transverse direction and/or longitudinal direction through the inside of the body of the single layer structure, and is formed with a specific curvature in some sections.

6. The semiconductor packaging module of claim 5, wherein the at least one first interconnect structure comprises a third interconnect structure and a fourth interconnect structure, and
wherein a curvature of the line of the third interconnect structure is a first curvature, and a curvature of the line of the fourth interconnect structure is a second curvature different from the first curvature.

7. The semiconductor packaging module of claim 5, wherein the body is formed to correspond to a shape of an empty space inside an electronic product in which the substrate is disposed.

8. The semiconductor packaging module of claim 7,
wherein the first end portion of the at least one first interconnect structure is connected to a first electronic component of the electronic device, and
wherein the second end portion is connected to a second electronic component of the electronic device.

9. The semiconductor packaging module of claim 8,
wherein a density of the at least one first interconnect structure in a first region of the substrate adjacent to the first electronic component is a first density, and
wherein a density of the at least one interconnect structure in a second region of the substrate adjacent to the second electronic component is a second density different from the first density.

10. The semiconductor packaging module of claim 8, wherein the body is formed to include at least one structure and/or at least one member in a portion other than the portion of the at least one first interconnect structure disposed.
